(19) Europäisches Patentamt
European Patent Office
Office européen des brevets

(11) **EP 2 672 299 B1**

(12) **EUROPEAN PATENT SPECIFICATION**

(45) Date of publication and mention
of the grant of the patent:
**07.01.2015 Bulletin 2015/02**

(21) Application number: **13183276.8**

(22) Date of filing: **25.05.2010**

(51) Int Cl.:
*G02B 3/08* (2006.01)
*F21V 17/12* (2006.01)
*F21V 9/00* (2015.01)
*F21S 8/10* (2006.01)
*G02B 17/08* (2006.01)
*H01L 33/58* (2010.01)
*F21Y 113/00* (2006.01)
*F21V 5/02* (2006.01)
*G02B 19/00* (2006.01)
*F21V 31/00* (2006.01)
*G02B 7/02* (2006.01)
*H01L 25/075* (2006.01)
*F21Y 101/02* (2006.01)
*F21V 29/00* (2015.01)

(54) **Gap member, lens and lighting device having the same**

Abstandselement, Linse und Beleuchtungsvorrichtung damit

Espaceur, lentille et dispositif d'éclairage l'utilisant

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **25.05.2009 KR 20090045342**
**05.06.2009 KR 20090049987**
**09.04.2010 KR 20100032961**
**10.04.2010 KR 20100033043**

(43) Date of publication of application:
**11.12.2013 Bulletin 2013/50**

(60) Divisional application:
**14195545.0**

(62) Document number(s) of the earlier application(s) in accordance with Art. 76 EPC:
**10163837.7 / 2 287 640**

(73) Proprietor: **LG Innotek Co., Ltd.**
**Seoul 100-714 (KR)**

(72) Inventors:
• **Lim, Dong Nyung**
**100-174 SEOUL (KR)**
• **Kim, Eun Hwa**
**100-714 SEOUL (KR)**
• **Hong, Sung Ho**
**100-174 SEOUL (KR)**
• **Kim, Hyun Min**
**100-714 SEOUL (KR)**

(74) Representative: **Cabinet Plasseraud**
**52, rue de la Victoire**
**75440 Paris Cedex 09 (FR)**

(56) References cited:
**WO-A1-2008/053753** **CN-A- 101 174 612**
**CN-A- 101 373 063** **CN-Y- 200 986 121**
**US-B1- 6 454 439**

**Description**

BACKGROUND OF THE INVENTION

Field of the Invention

An embodiment relates to a gap member, a lens, and a lighting device having the same, in more detail, a gap member for a lighting device, a lens for a lighting device which has efficient luminance distribution on the surface through which light travels, and a lighting device having the gap member and the lens.

Description of the Related Art

Since LEDs (Light Emitting Diode) consume small power, has a long life span, and can be operated at a low cost, they are used as light sources for various electronic components, electronic display boards, and lighting devices etc. However, it is required to overcome problems, such as high prices, vulnerability to heat or humidity, low color rendering, and low luminance, in order to replace the existing light sources with the LEDs.
Lighting devices for achieve desired discharge light characteristics by additionally providing a lens to the LEDs have been proposed in the art. In general, there are lenses for diffusing light to achieve a wide radiation surface and lenses for concentrating light having high luminance on a wide radiation surface, in lenses for lighting devices.
Further, as disclosed in documents CN 101 174 612 A and EP2078736A1, a reflective plate is increasingly formed around the LEDs to increase efficiency of the light radiated from LED lamps, and a member that spaces a lens and an LED by a predetermined distance is provided in some lighting devices additionally equipped with the lens in order to prevent contact between the lens and the LED.

SUMMARY OF THE INVENTION

The invention is directed to a lighting device as claimed in claim 1. Preferred embodiments are defined in the dependent claims.

BRIEF DESCRIPTION OF THE DRAWINGS

FIG. 1 is a side view showing a lighting unit according to a first embodiment;
FIG. 2 is a side cross-sectional view of a light emitting unit of FIG. 1;
FIG. 3 is a plan view of the light emitting unit of FIG. 1;
FIG. 4 is a view showing another example of the light emitting unit of FIG. 1;
FIG. 5 is a view showing another example of the light emitting unit of FIG. 1;
FIG. 6 is a view showing another example of the light emitting unit of FIG. 1;
FIG. 7 is a side cross-sectional view a gap member of FIG. 1;
FIG. 8 is a perspective view of the gap member of FIG. 1;
FIG. 9 is a plan view of the gap member of FIG. 1;
FIG. 10 is a bottom view of the gap member of FIG. 1;
FIG. 11 is a perspective view of another example of the gap member of FIG. 1;
FIG. 12 is a plan view of another example of the gap member of FIG. 1;
FIG. 13 is a bottom view of another example of the gap member of FIG. 1;
FIG. 14 is a view showing a radiation surface when luminance distribution makes a circle;
FIG. 15 is a view showing a radiation surface when luminance distribution makes a square;
FIG. 16 is a side cross-sectional view of a lens with an incident surface of only a prism surface and a flat exit surface;
FIG. 17 is a view showing spatial light distribution by a lighting unit including the lens of FIG. 16;
FIG. 18 is a side cross-sectional view of a lens with an incident surface of only a prism surface and a spherical exit surface;
FIG. 20 is a view showing spatial light distribution by a lighting unit including the lens of FIG. 18;
FIG. 21 is a perspective view of a lens with an incident surface of a prism surface and a furrow surface, and a spherical exit surface;
FIG. 22 is a plan view of a lens with an incident surface of a prism surface and a furrow surface, and a spherical exit surface;
FIG. 23 is a side cross-sectional view of a lens with an incident surface of a prism surface and a furrow surface, and a spherical exit surface;

FIG. 24 is a view showing light paths of light emitted from LEDs of the lighting unit of FIG. 1;

FIG. 25 is a view showing spatial light distribution by a lighting unit using the lens of FIG. 21;

FIG. 26 is a view showing spatial light distribution by a lighting unit using the lens of FIG. 21;

FIG. 27 is a view showing luminance distribution of a radiation surface according to an FTE Calculator;

FIG. 28 is a view showing spatial light distribution by a lighting unit using a lens of en experimental example 5;

FIG. 29 is a view showing spatial light distribution by a lighting unit using the lens of the experimental example 5;

FIG. 30 is a side cross-sectional view showing a lighting unit according to a second example

FIG. 31 is a side cross-sectional view showing a lighting unit according to a third example

FIG. 32 is a side cross-sectional view showing a lighting unit according to a fourth example

FIG. 33 is an exploded perspective view of a lighting device according to a sixth embodiment;

FIG. 34 is a perspective view of a lighting device according to the sixth embodiment, seen from above;

FIG. 35 is a perspective view of the lighting device according to the sixth embodiment, seen from below;

FIG. 36 is cross-sectional view of the lighting device according to the sixth embodiment;

FIG. 37 is a view showing a light emitting unit of a lighting device;

FIG. 38 is a perspective view of a lighting device according to a seventh embodiment, seen from above;

FIG. 39 is cross-sectional view of a lighting device according to an eighth embodiment; and

FIG. 40 is a perspective view of a lighting device according to a ninth embodiment, seen from above.

## DETAILED DESCRIPTION OF THE PREFERRED EMBODIMENTS

In describing the embodiments, the reference of the "above" or "below" of each layer is, if not specifically stated, is assumed that the side where a lens 140 is the "above" and the side where a light emitting unit 101 is the "below".

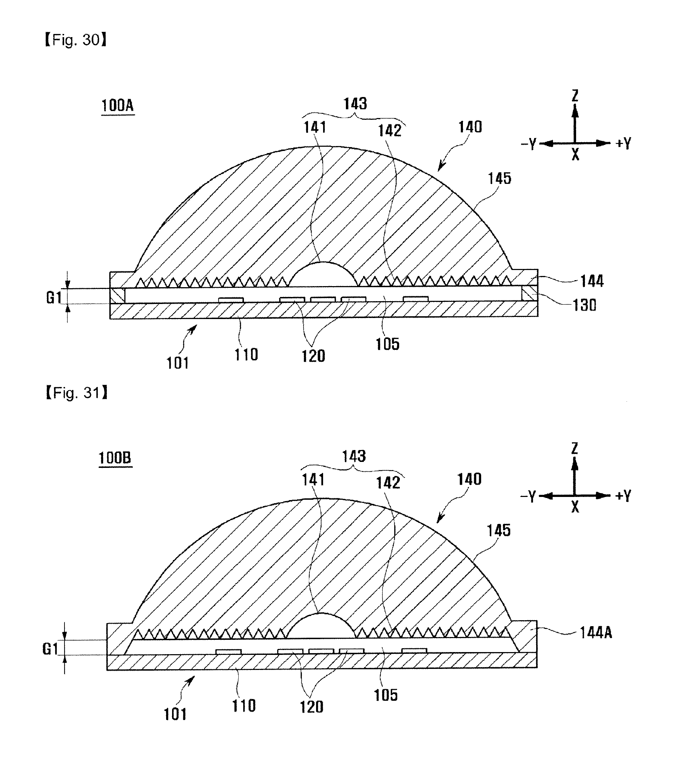

In describing the embodiments, although a lighting unit 100 implies the component including a lens 140, a gap member 130, and a light emitting unit 101, when a specific gap member does not exist, as in FIG. 31, the lighting unit 100 implies the component including the lens 140 and the light emitting unit 101. The first to fifth embodiments describe the lighting unit 100, and the others, including the sixth embodiment, describe lighting devices.

When an axis of coordinates representing a space is shown in the figures, the axis of coordinates will be first described. The thickness or size of each layer was exaggerated, omitted, or schematically shown in the figures, for the convenience and clarity of description. Further, the size of each component does not completely represent the actual size. Embodiments are described hereafter with reference to the accompanying drawings, as follows.

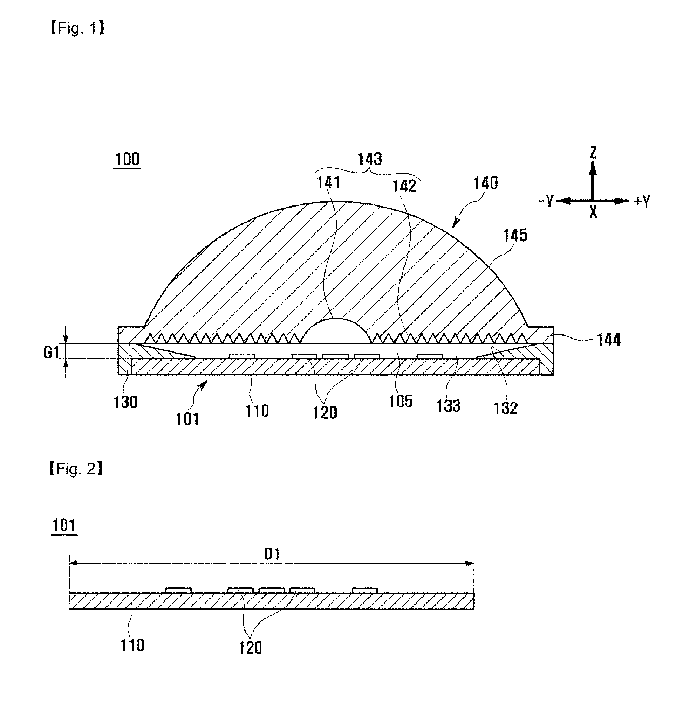

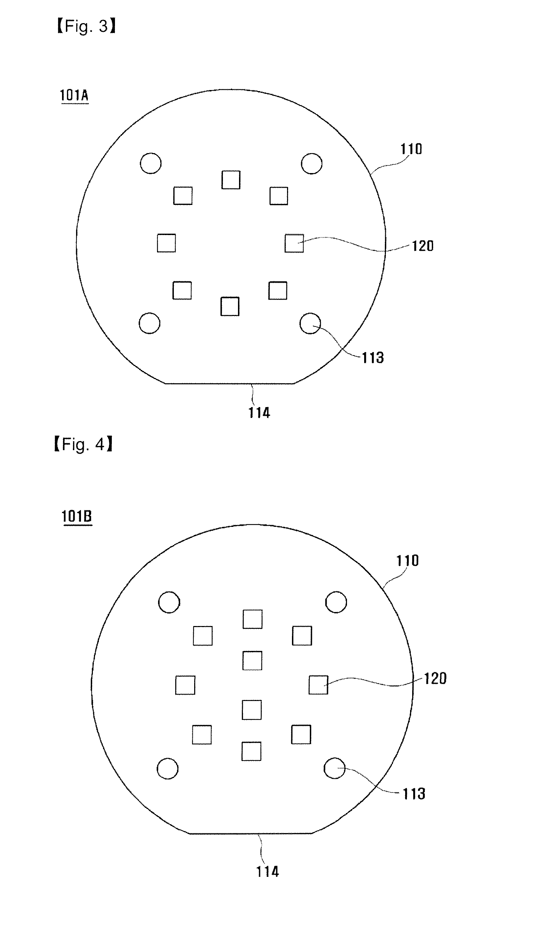

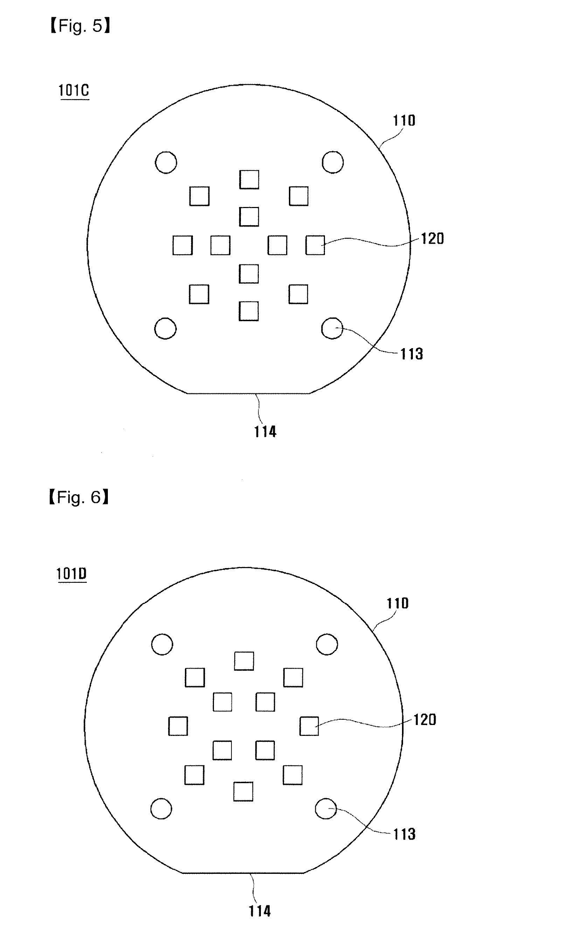

FIG. 1 is a side view showing a lighting unit according to a first embodiment, FIG. 2 is a side cross-sectional view of a light emitting unit of FIG. 1, FIG. 3 is a plan view of the light emitting unit 101 of FIG. 1, FIG. 4 is a view showing another example of the light emitting unit 101 of FIG. 1, FIG. 5 is a view showing another example of the light emitting unit 101 of FIG. 1, and FIG. 6 is a view showing another example of the light emitting unit of FIG. 1.

Referring to FIG. 1, a lighting unit 100 includes a light emitting unit 101, a gap member 130, and a lens 140. The lighting unit 100 can be mounted in street lamps disposed at regular intervals, exterior lamps, such as outdoor lamps, and illuminate with appropriate light distribution and luminance distribution for the front of the external lamps and the regions between street lamps and outdoor lamps.

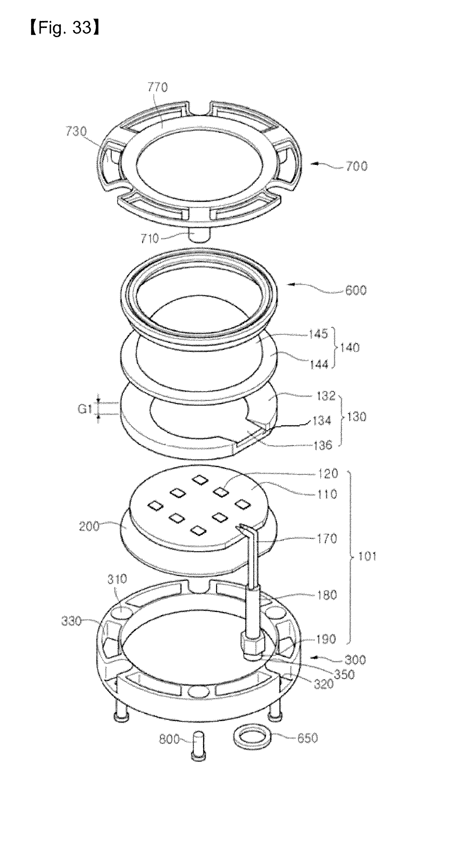

The light emitting unit 101 is equipped with a plurality of LEDs 120 on a substrate 110 and the arrangement of the LEDs 120 can be modified in various ways. Although FIGS. 2 to 6 mainly show the substrate 110 and the LEDs 120 in the components of the light emitting unit 101, as shown in FIGS. 33, 36, 37 and 39, the light emitting unit 101 may additionally include a lead electrode 170, a protective tube 180, and a connecting terminal 190.

The substrate may be an aluminum substrate, a ceramic substrate, a metal core PCB, and a common PCB etc. Further, the substrate 110 is made of a material efficiently reflecting light, or the surface may have a color efficiently reflecting light, such as white and silver. The LEDs 120 include a white Led, or it is possible to selectively 160°or may include a Lamertian shape (perfect diffused surface).

The substrate 110 of the light emitting unit 101, as shown in FIGS. 2 and 3, is a circular plate having a predetermined diameter D1 and the diameter D1 has a size that can be accommodated under the gap member 130. A flat portion 114 may be formed at a predetermined portion of the outer circumference of the substrate 110, in which the flat portion 114 indicates the joint between components or prevents rotation therebetween.

A plurality of screw holes 113 may be formed in the substrate 110 to fasten the substrate 110 to structures, such as street lamps and outdoor lamps, or fasten the substrate 110 to the case of the lighting unit 110, by screwing screws into the screw holes 113. In this configuration, not only screws, but rivets or hooks may be inserted in the screw holes 113. The substrate 110 may not have the screw holes 113.

The light emitting unit 101A of FIG. 3 has eight LEDs 120 arranged on the substrate 110, and for example, the eight LEDs 120 may be arranged at regular intervals on a circle having a predetermined radius from the center of the substrate 110. The eight LEDs 120 may be arranged not only the circle, but an ellipse or a rectangular.

The light emitting unit 101 B of FIG. 4 has ten LEDs 120 arranged on the substrate 110, and for example, an example in which eight LEDs 120 are arranged at regular intervals on a circle having a predetermined radius from the center of the substrate and two LEDs are arranged inside the circle is shown.

The light emitting unit 101C of FIG. 5 has twelve LEDs 120 arranged on the substrate 110, and for example, an example in which eight LEDs 120 are arranged at regular intervals on a circle having a predetermined radius from the center of the substrate and four LEDs are arranged at regular intervals on a coaxial circle having a radius smaller than the above circle is shown.

According to the light emitting unit 101 D shown in FIG. 6, as compared with FIG. 5, all of the LED 120 on the smaller circle may be rotated at 45° from the center of the substrate.

The arrangements of LED 120 shown in FIGS. 3 to 6 are examples, the distance between the LEDs 120 arranged on the circles may not be uniform in accordance with desired shapes of the radiation surface, and the shape of arrangement and the number of the LEDs 120 on the substrate 110 may be changed in accordance with intensity of light, light distribution, and luminance distribution, and may also be changed with the technological range of the embodiments. If the term, light emitting unit 101, is used in the drawings or the specification without specifying understood that the term represents the light emitting units having those arrangements.

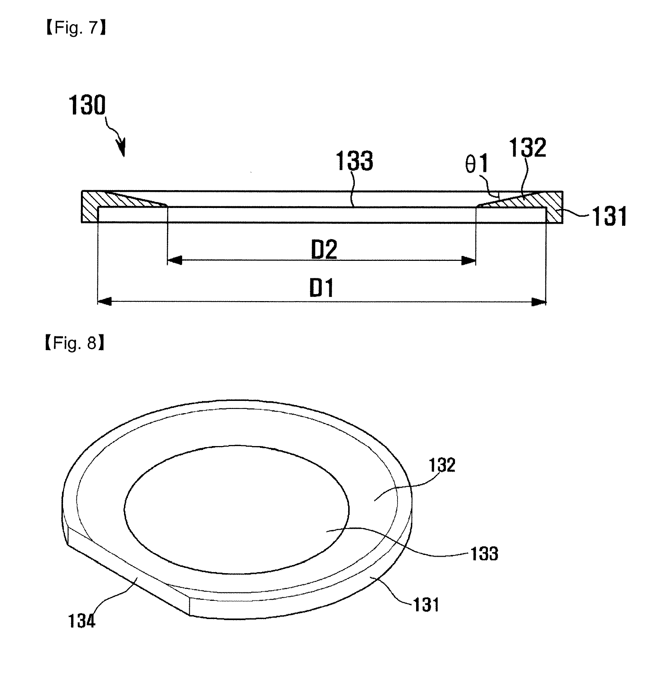

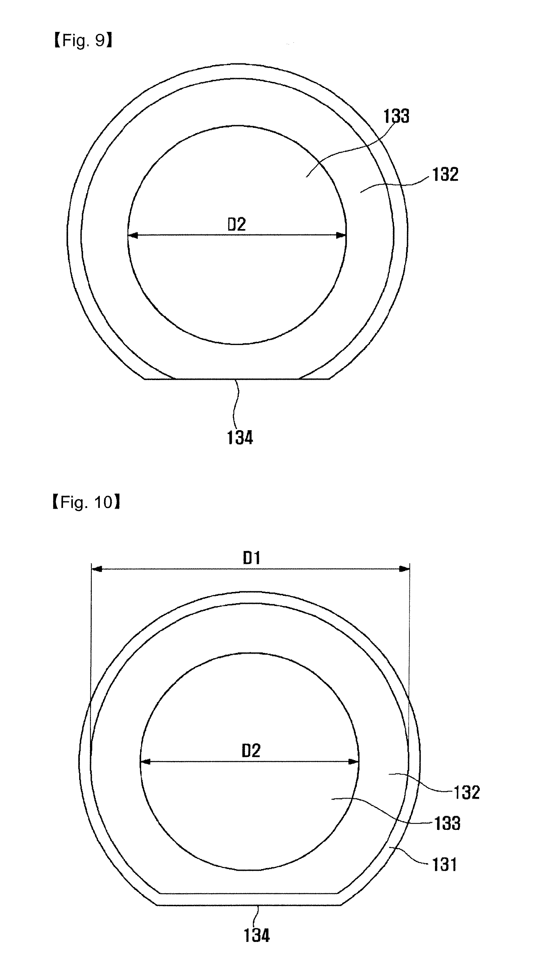

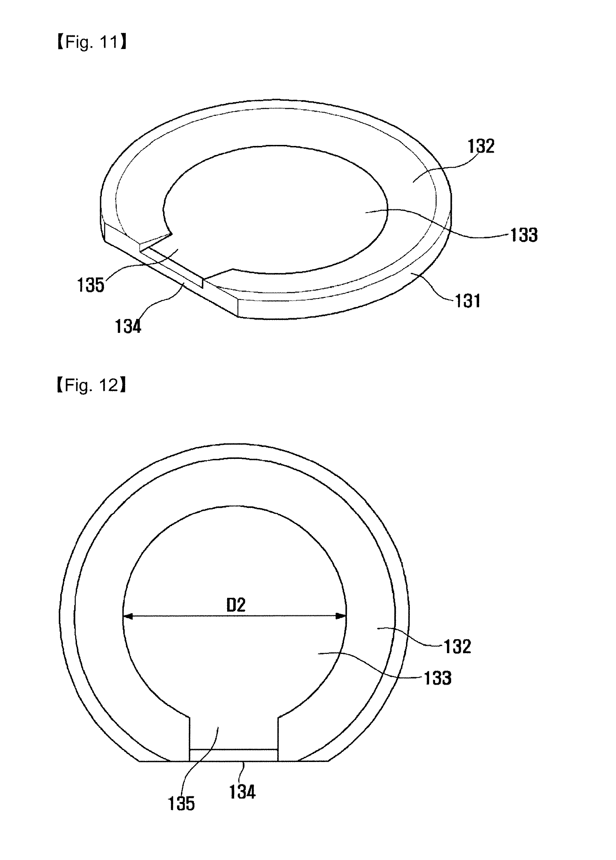

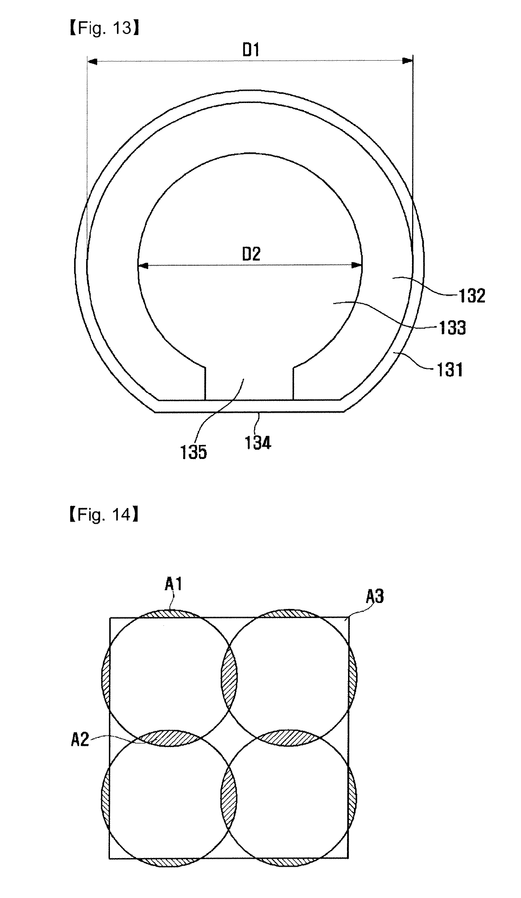

FIG. 7 is a side cross-sectional view a gap member 130 of FIG. 1, FIG. 8 is a perspective view of the gap member 130 of FIG. 1, FIG. 9 is a plan view of the gap member 130 of FIG. 1, FIG. 10 is a bottom view of the gap member 130 of FIG. 1, FIG. 11 is a perspective view of another example of the gap member 130 of FIG. 1, FIG. 12 is a plan view of another example of the gap member 130 of FIG. 1, and FIG. 13 is a bottom view of another example of the gap member 130 of FIG. 1.

Referring to FIG. 1 and FIGS. 7 to 13, the gap member 130 has a reflective portion 132 declined toward the center in a ring shape and a wall 131 extending down coaxially with the reflective portion 132 in a ring shape. Further, the gap member 130 has an entirely flat ring shape, such that it has an opening having a diameter that is the inner diameter of the reflective portion 132.

The reflective portion 132 can increase light efficiency of a lighting device by allowing the light emitted from the LEDs to be reflected without disappearing. Light is reflected upward from the reflective portion 132, such that the reflective portion 132 helps the light travel upward.

The bottom of the reflective portion 132 is in contact with the edge of the upper surface of the light emitting unit 101 and the inner circumference of the wall 131 is in contact with the outer circumference of the light emitting unit 101, such that the light emitting unit 101 is seated in the gap member 130. In order to prevent the light emitting unit 101 from separating upward from the gap member 130, the inner diameter of the reflective portion 132 is smaller than the inner diameter of the wall 131 and the outer diameter of the light emitting unit 101.

Further, the gap member 130 spaces the substrate 110 and the lens 140 by a predetermined gap G1. Since the gap is larger than or the same as the thickness of the LEDs 120 arranged on the substrate 110, the lens 140 dose not press the LEDs 120 and a space is defined between the lens 140 and the substrate 110, such that it is possible to achieve a light emitting angle and light distribution.

Further, the gap member 130 prevents contact between other members, such as the case of a lighting device, and other surfaces, except for the bottom of the light emitting unit 101, and when the gap member 130 is made of an insulating material, the gap member 130 and the light emitting unit 101 are insulated. In addition, it is possible to prevent problems, such as electric short, EMI, and EMS, in the light emitting unit 101 and improve voltage light emitting unit 101.

The space 105 may be filled with silicon or silicon resin. The LEDs 120 of the light emitting unit 101 are exposed through the opening 133 and a flange 144 of the lens 140 is disposed on the upper surface of the gap member 130.

A flat portion 134 may be formed at a predetermined portion of the substrate 130, in which the flat portion 134 indicates the joint between components or prevents rotation therebetween. To be more specific, embodiments are assumed, such as the substrate 110 of the light emitting unit 1101 shown in FIGS. 3 to 6 in which the flat portion 114 is formed at a predetermined portion of the substrate 110, and such as the gap member 130 shown in FIGS. 8 to 13 in which the flat portion 134 is formed in the gap member 130. Referring to FIGS. 10 to 13, since not only the outer side, but the inner side of the flat portion 134 of the gap member 130 is flat, the substrate 110 is fitted in the gap member 130, with the two flat portions 114 and 134 in contact with each other. Since predetermined portions of the inner circumference of the wall 131 and the outer circumference of the substrate 110 are flat, they are not rotated or moved from the positions.

The reflective portion 132 extends at a predetermined inclination from the upper surface of the wall 131 toward the center of the opening 133. That is, the reflective portion 132 is declined at a predetermined angle θ1 from the outer edge of the opening 133 of the gap member 130. A prism surface 142 of the lens 140 is disposed at a distance above the inclined surface of the reflective portion 132, such that the amount of reflected light an be changed in accordance with the width off the inclination angle θ1 and the width of the reflective portion 132. The opening 133 inside the reflective portion 132, as shown in FIGS. 8 to 10, is formed in a circle having a predetermined diameter D2.

The light reaching the reflective portion 132, in the light emitted from the LEDs 120, are reflected from the reflecting portion 132 and travels outside through the lens 140. Therefore, additional effect of improving light efficiency is achieved as compared with common gap members without the reflective portion 132. It was described already that the gap member 130 according to this embodiment improves voltage resistance as compared with common gap members.

As shown in FIGS. 11 to 13, and 17, the gap member 130 may have an electric wire (not shown) connected to the substrate 110 or an electrode-through portion 135 through which the lead electrode 170 passes.

In FIGS. 8 to 13, only the gap member 130 having the flat portion 134 is shown and the gap member 130 having the flat portion 134 is a preferred embodiment. However, the gap member 130 having an entirely circular shape without the flat portion 134 may rotate or move from the position between the parts, but except for this defect, it has all the effects of improvement of light efficiency and voltage resistance, which the gap member 130 of the embodiments described above has, and accordingly, it should be understood that not the gap member 130 having the flat portion 134 was limitatively described, but optimal embodiments were described.

Before describing the shape and structure of the lens 140, the lens 140 proposed in the embodiments relating to the present invention is the lens 140 used for lighting unit 100 that is usually mounted in exterior lights, such as street lamps and outdoor lamps; therefore, it needs to see first what the efficient luminance distribution is in the lens 140.

Efficient Luminance distribution

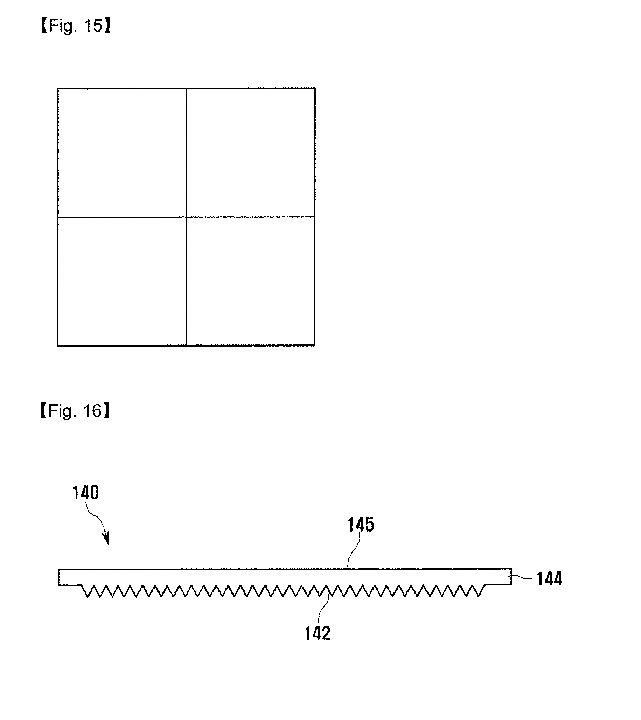

FIG. 14 is a view showing a radiation surface when luminance distribution makes a circle and FIG. 15 is a view showing a radiation surface when luminance distribution makes a square.

Referring to FIGS. 14 and 15, it can be seen that efficiency is high when the light emitted from the lighting unit 100 makes rectangular luminance distribution as compared when it is a circle, by reducing waste of light A2 due to overlap of light and dead angel areas A3, and also reducing light A1 radiated to regions that do not need to be illuminated.

Compare a street lamp and an external lamp using the lighting unit 100 having the circular luminance distribution with a street lamp and an external lamp using the lighting unit 100 having the square luminance distribution. The latter can improve luminance distribution between adjacent street lamps or adjacent outdoor lamps and reduce or remove the dead angle areas A3 in comparison with the former, such that it is possible to make the distance between the street lamps or the outdoor lamps larger in the latter than the former. Further, since it is possible to reduce the number of necessary street lamps or outdoor lamps to achieve desire luminance, the maintenance and operational cost can be saved.

Although an example of the square luminance distribution in quadrilaterals was shown in FIG. 15, it is advantageous to make rectangular luminance distribution, not the square, in order to illuminate a narrow and long region, such as the street lamps illuminating roads and the outdoor lamps. Therefore, any one of the rectangular luminance distribution and the square luminance distribution may be advantageous relatively to the other, depending on the usage of the lighting unit 100.

The structure of the lens 140 for achieving rectangular luminance distribution will be gradually described hereafter.

Structure of Lens for Achieving Asymmetric Luminance Distribution-Incident Surface Including Prism Surface

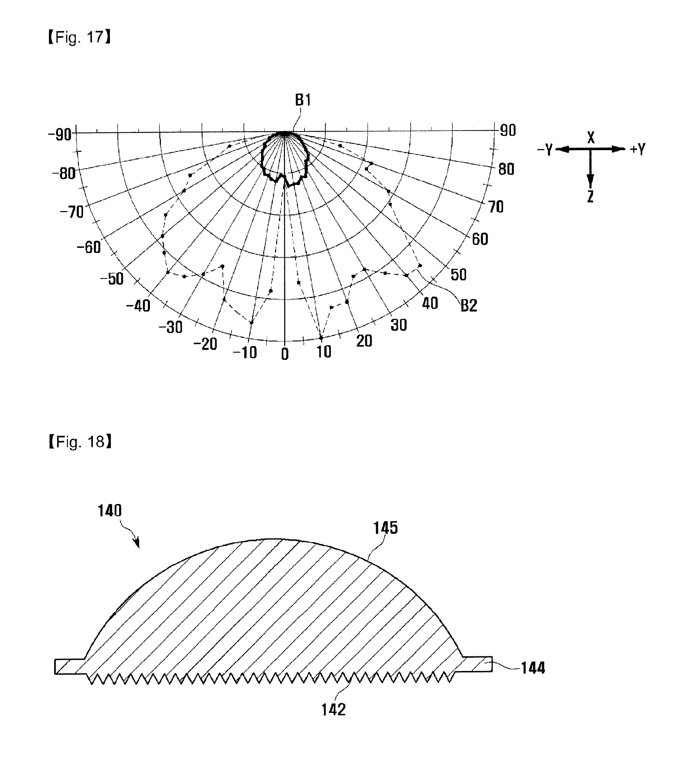

FIG. 16 is a side cross-sectional view of a lens with an incident surface 143 of only a prism surface 142 and a flat exit surface 145 and FIG. 17 is a view showing spatial light distribution by the lighting unit 100 including the lens 140 of FIG. 16.

Referring to FIG. 17, light distribution when the lighting unit 100 is seen from the front in the X direction is shown as B2 and light distribution when the lighting unit 100 is seen from the front in the Y direction is shown as B1. The reason that B2 is wider than B1 is because light is diffused in the Y direction by the prism surface 142. Therefore, this asymmetric luminance distribution is a relatively approximate rectangle, rather than circular luminance distribution. However, because the prism surface 142 disperses the light to the outside, the center portion is shown relatively darker than other radiation surfaces, when the lighting unit is seen in the X direction (B2). Further, similarly, the light width is small and the center portion is relatively darker than other radiation surfaces, when seen in the Y direction (B1).

Accordingly, the luminance distribution is not uniform in the lens with the incident surface 142 of only the prism surface 142 and the flat exit surface 145. Further, when a plurality of lighting devices are used, there are unnecessarily many overlaps of light and many dark dead angle areas are made to reduce wasted portions due to overlap of light, such that it is still difficult to efficiently operate the lighting devices.

Therefore, it is described when the exit surface 145 is a spherical lens 140, as a structure of the lens 140 that can compensate diminished luminance at the center portion of the radiation surface.

Structure of Lens Capable of Compensate Luminance Diminished at Center of Radiation Surface - Lens with Spherical Exit Surface

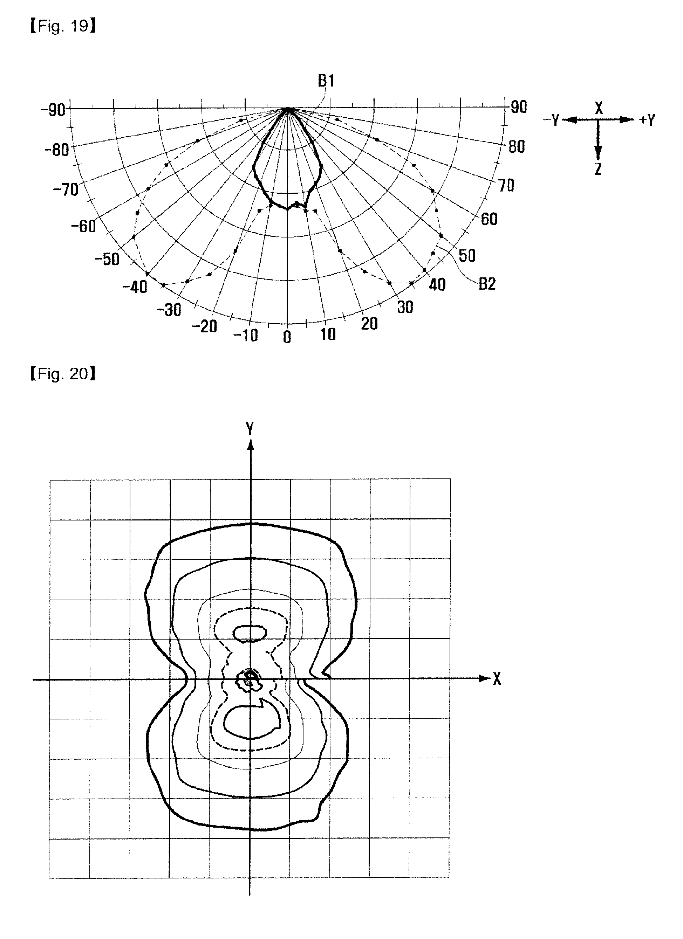

FIG. 18 is a side cross-sectional view of a lens with an incident surface 143 of only a prism surface and a spherical exit surface 145, FIG. 19 is a view showing spatial light distribution by a lighting unit 100 including the lens 140 of FIG. 18, and FIG. 20 is a view showing spatial light distribution by a lighting unit 100 including the lens 140 of FIG. 18.

Comparing FIG. 17 with FIG. 19, it can be seen that light intensity was improved in comparison with the lens 140 with the flat exit surface 145, when seen from the Y-axis (B1) and the light intensity was significantly improved at the center portion when seen from the X-axis (B2). However, the light intensity is still small at the center portion, and referring to FIG. 20, the luminance distribution shows a shape of a dumbbell or butterfly in the radiation surface. As a result, since it is still impossible to achieve luminance distribution of an approximate rectangle with the lens 140 with the incident surface 143 of only the prism surface 142 and the spherical exit surface 145, it needs to additionally consider a lens 140 having a furrow surface on the incident surface 143.

Lens With Incident Surface Having Furrow Surface

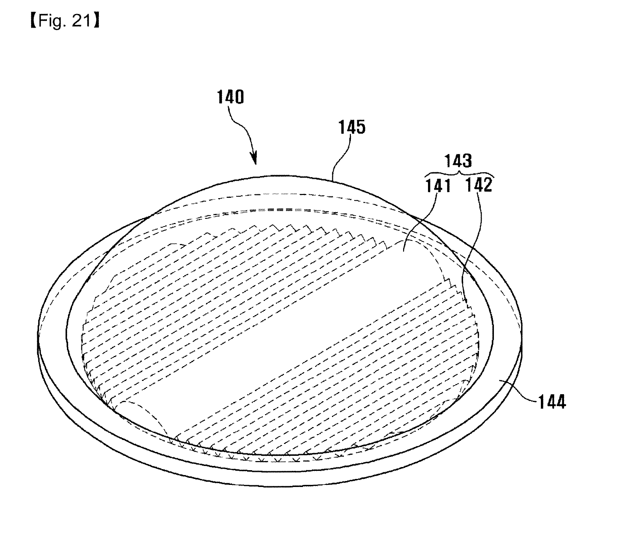

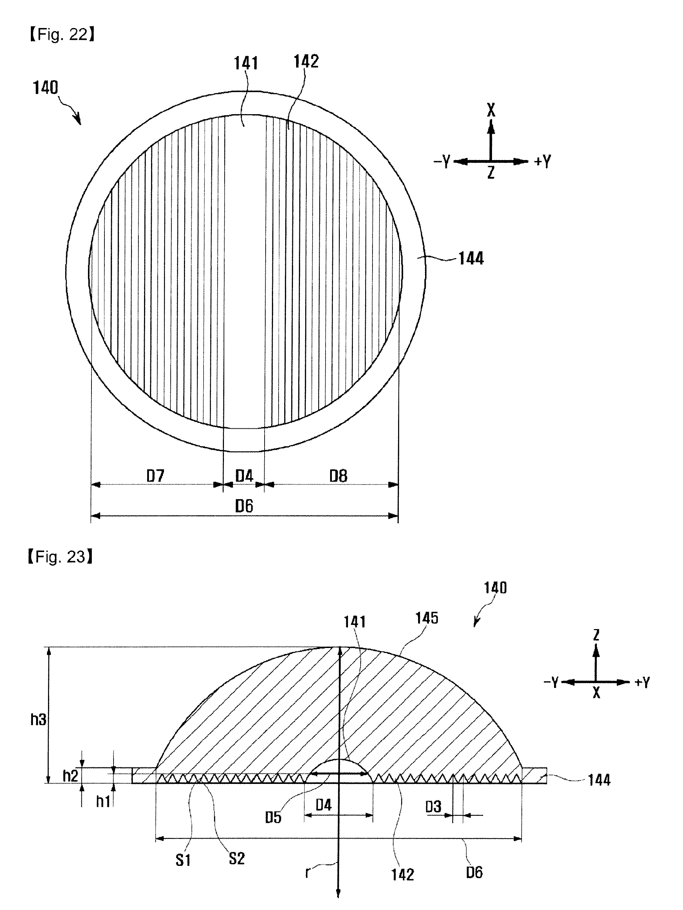

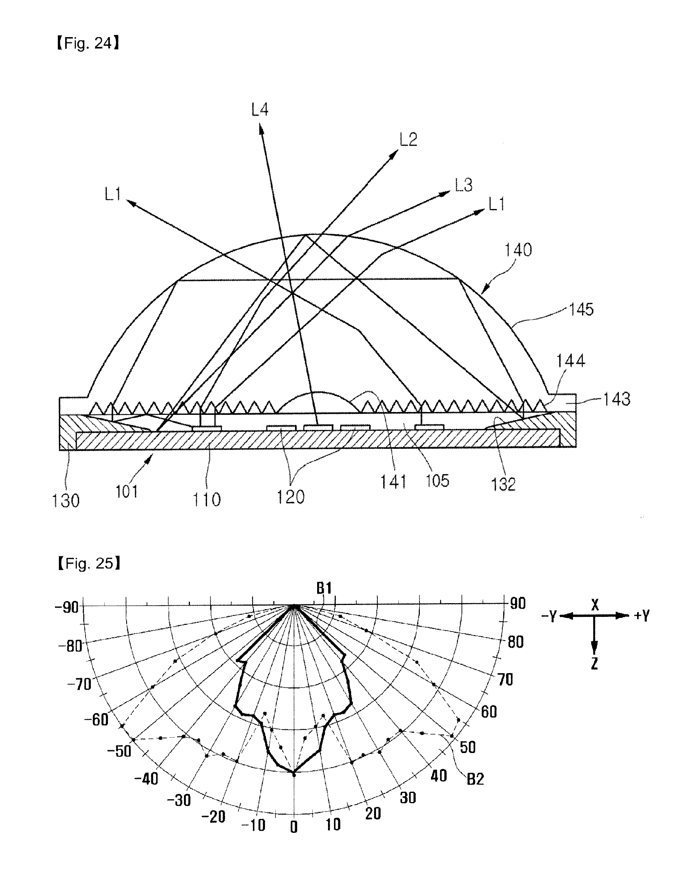

The entire configuration of a lens 140 with an incident surface 143 having a furrow surface 141 and the configuration of a lighting unit 100 including the lens are described first. FIG. 21 is a perspective view of a lens 140 with an incident surface 143 of a prism surface 142 and a furrow surface 141, and a spherical exit surface 143, FIG. 22 is a plan view of a lens 140 with an incident surface143 of a prism surface 142 and a furrow surface 141, and a spherical exit surface, FIG. 23 is a side cross-sectional view of a lens 140 with an incident surface 143 of a prism surface 142 and a furrow surface 141, and a spherical exit surface 145, and FIG. 24 is a view showing light paths of light emitted from LEDs 120 of the lighting unit 100 of FIG. 1.

Referring to FIG. 1 and FIGS. 21 to 23, the lens 140 is disposed above the light emitting unit 101. The lens 140 has the incident surface 143 and the exit surface 145, and the furrow surface 141 and the prism surface 14t2 are formed at the incident side. A circular flange 144 is formed around the incident surface 143 of the lens 140.

The lens 140 may be formed by injection-molding a light transmissive material, and the material may be glass and plastic, such as PMMA (Poly methyl methacrylate) and PC (Polycarbonate).

The incident surface 143 is perpendicular to the light axis, and the furrow surface 142 transverses the incident surface, preferably through the center of the incident surface 143. Referring to FIGS. 1 and 22, it can be seen that the furrow surface 141 is formed in the X-axis direction perpendicular to the light axis Z. The furrow surface 141 may have an arc cross section when cut along a plane (YZ-plane) perpendicular to the longitudinal direction of the furrow surface 141, or may have shapes of portions of a parabola, a hyperbola, and an ellipse. As a result, the furrow surface 141 has a round shape when seen from the incident surface 143, and in more detail, it has a depressed surface of a cut cylinder, when cut along a plane parallel with the longitudinal direction of the cylinder. Further, the width D4 of the furrow surface 141 may be 9% ~ 40% of the diameter D6 of the incident surface.

The prism surfaces 142 are formed at both sides of the furrow surface 141. The prominences and depressions of the prism surface 142 extend in the axis X direction perpendicular to the light axis Z, in which the prominences and depressions are continuously arranged in the direction -Y, +Y which is perpendicular to the longitudinal direction X of the furrow surface 141 and the light axis Z. The prominences and depressions have a triangular cross section, when they are cut along a plane YZ perpendicular to the longitudinal direction of the furrow surface 141 of the prism surface 142. Both sides S1 and S2 of the triangular prominences may be the same or different in length and angle.

Further, the gap between the prominences and depressions of the prism 142 may be constant or becomes smaller toward both sides -Y-axis and +Y-axis. This density depends on the light distribution.

The prism surface 142 is positioned between the furrow surface 141 and the flange 144. The prism surface 142 can increase the light distribution in the left-right direction -Y,+Y by being arranged in the side direction perpendicular to the longitudinal direction, for example in the left-right direction -Y,+Y.

The exit surface 145 can reflect or refract incident light to the outside. The exit surface 145 may be a non-spherical lens or a spherical lens and the shape of non-spherical lens or spherical lens can be selected in consideration of light distribution and luminance distribution.

Reflected light, which does not travel outside through the exit surface 145, travels through the exit surface 145 while the light emitting angle changes through at least one of the prism surface 142, the reflective unit 132, and the upper surface of the substrate 110.

Referring to FIG. 24, in the light L1, L2, and L3 emitted from the outermost LEDs 120 of the light emitting unit 110, the light L1 and L2 travel outside through the prism surface 142 and the exit surface 145, while the light L3 is reflected and travels outside through the exit surface 145, with the critical light angle changed sequentially through the reflective unit 132, the prism surface, the exit surface 145, and the prism surface 142.

The light L4 emitted from the LED 120 at the center of the light emitting unit 110 is refracted and diffused through the furrow surface 141 of the lens 140 and travels outside through the exit surface 145.

The structures of the lens 140 with an incident surface 143 having a furrow surface 141 and the lighting unit 100 including the lens 100 was seen above, and spatial light distribution and luminance distribution are described hereafter.

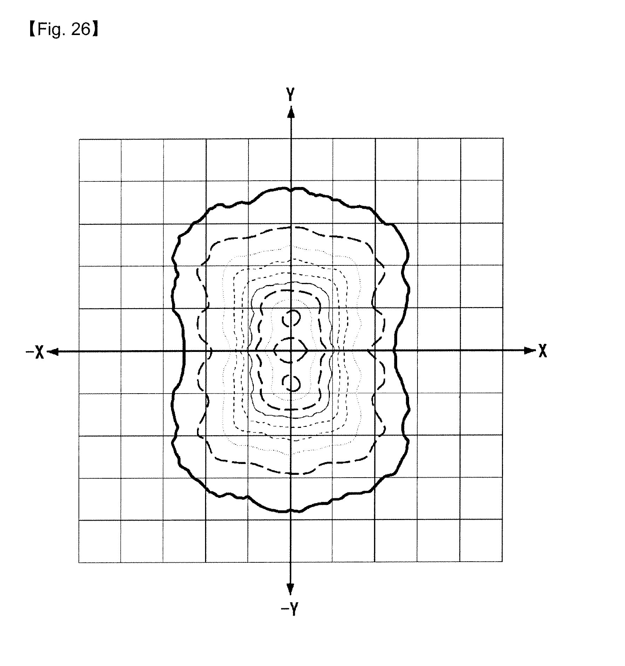

FIG. 25 is a view showing spatial light distribution by a lighting unit 100 using the lens 140 of FIG. 21 and FIG. 26 is a view showing spatial light distribution by a lighting unit 100 using the lens 140 of FIG. 21. Referring to FIG. 25, light distribution when the lighting unit 100 is seen from the front in the X direction is shown as B2 and light distribution when the lighting unit 100 is seen from the front in the Y direction is shown as B1. The reason that B2 is wider than B1 is because light is diffused in the Y direction by the prism surface 142. Unlike FIG. 19, however, since the lens 140 has the furrow surface 141, it can be seen that spatial light distribution was improved, when seen from the X-axis and the Y-axis. That is, the light distribution is considerably large around the light axis Z, as compared with FIG. 19. Further, when seen from the Y-axis direction (B1), light width is large and more light are radiated to the radiation surface in comparison with FIG. 19, and when seen from the X-axis direction (B2), relatively darker regions than other radiation surface are significantly reduced around the X-axis, as compared with FIG. 19.

Referring to FIG. 26, the radiation region where light is radiated has an approximate rectangular shape, when the light is radiated through the lens 140. This shape has a remarkable difference from the dumbbell or ribbon shape of FIG. 20. Similar to FIG. 17, it is an effect of the prism surface 142 that the light is diffused in the Y-axis direction and it is an effect of the furrow surface 141 that light is radiated without making the region around the X-axis dark. As compared with the lens 140 shown in FIG. 18, the furrow surface 141 additionally provided to the lens of FIG. 21 functions as a luminance reinforcement surface that compensate the luminance in the center region of the radiation surface.

When the exit surface 145 is a spherical lens or a non-spherical lens is described in detail with reference to FIG. 23. In this configuration, h1 is the thickness of the prism surface, h2 is the thickness of the flange 144, h3 is the thickness of the lens 140, D3 is the gap between adjacent prism, D4 is the width of the furrow surface 141, D6 is the width of the lens 140 except for the flange 144, r is the radius of curvature of the exit surface 145, S1 is one side in the cross section of the prism surface 142, and S2 is the other side in the cross section of the prism surface 142. A formula representing the spherical lens-shaped exit surface 145 is as <Formula 1>.

[Formula 1]
$$z = \frac{\frac{1}{r}(\frac{D6}{2})^2}{1 + \sqrt{1 - (\frac{1}{r})^2(\frac{D6}{2})^2}}$$

In <Formula 1>, the relationship of $(\frac{D6}{2})^2 = x^2 + y^2$ is satisfied, z is the height from the incident surface 143 to the exit surface 145, D6 is the width of the lens 140 except for the flange 144, and r is the radius of curvature of the exit surface 145.

A formula representing the conical lens-shaped exit surface 145 is as <Formula 2>.

[Formula 2]
$$z = \frac{\frac{1}{r}(\frac{D6}{2})^2}{1 + \sqrt{1 - (1+k)(\frac{1}{r})^2(\frac{D6}{2})^2}}$$

In <Formula 1>, the relationship of $(\frac{D6}{2})^2 = x^2 + y^2$ is satisfied, z is the height from the incident surface 143 to the exit surface 145, D6 is the width of the lens 140 except for the flange 144, r is the radius of curvature of the exit surface 145, and k is a conic constant.

A formula representing the non-spherical lens-shaped exit surface 145 is as <Formula 3>

[Formula 3]

$$z = \frac{\frac{1}{r}(\frac{D6}{2})^2}{1+\sqrt{1-(1+k)(\frac{1}{r})^2(\frac{D6}{2})^2}} + \sum_{n=2}^{10} C_{2n}(\frac{D6}{2})^{2n}$$

The symbols in <Formula 3> are the same as those in <Formula 2>, and $C_{2n}$ is a non-spherical surface constant. Any spherical surface of non-spherical surface may be used for the shape of the exit surface 145, as long as they satisfy <Formula 1>, <Formula 2>, and <Formula 3>, In particular, the shape depends on the conic constant k in <Formula 2>, that is, it becomes a sphere at K=0, an ellipse at -1<k<0, a parabola at K=1, a hyperbola at k<-1, and an oblate spheroid at k>0.

Since there are a lot of cases when the exit surface 145 satisfies the formulae and efficiency of the lighting unit 100 is seen for each case, by way of several representative examples. Simulation data acquired by executing a computer program, FTE Calculator, in order to see the efficiency of the lighting unit 100 and the object of the simulation using the computer program is to acquire certification from Energy Star and inspect the efficiency of the lighting unit 100 at the same time. Accordingly, certification from Energy Star and simulation data are examined hereafter.

Certification from Energy Star and Examination of Light efficiency of Radiation Surface

Energy Star is an international program about energy efficiency in the United States and also a common program of DOE and EPA of the United States, and gives a mark "ENERGY STAR" to product satisfying a guide line in energy efficiency. Many consumers prefer to products acquired the mark from Energy Star in the Unite States and the merits of the product acquiring the mark from Energy Star are different in the state governments, such that acquiring certification from Energy Star largely helps improve commercial value of products.

Certification from Energy Star means that lighting devices can illuminate a desired region to illuminate with less power at predetermined luminance and the number of necessary lighting device can be reduced, such that they can be considered as high-efficiency lighting devices.

In the embodiments proposed in connection with the present invention, the proposed lenses 140 are the lenses 140 that is used the lighting units 100 generally mounted in external lamps, such as street lamps and outdoor lamps; therefore, they have to satisfy Outdoor Area & Parking Garage of Category A in the standard of Energy Star. The computer program, FTE Calculator, is used to check whether the standard is satisfied and it is clear that those skilled in the art can easily obtain the computer program.

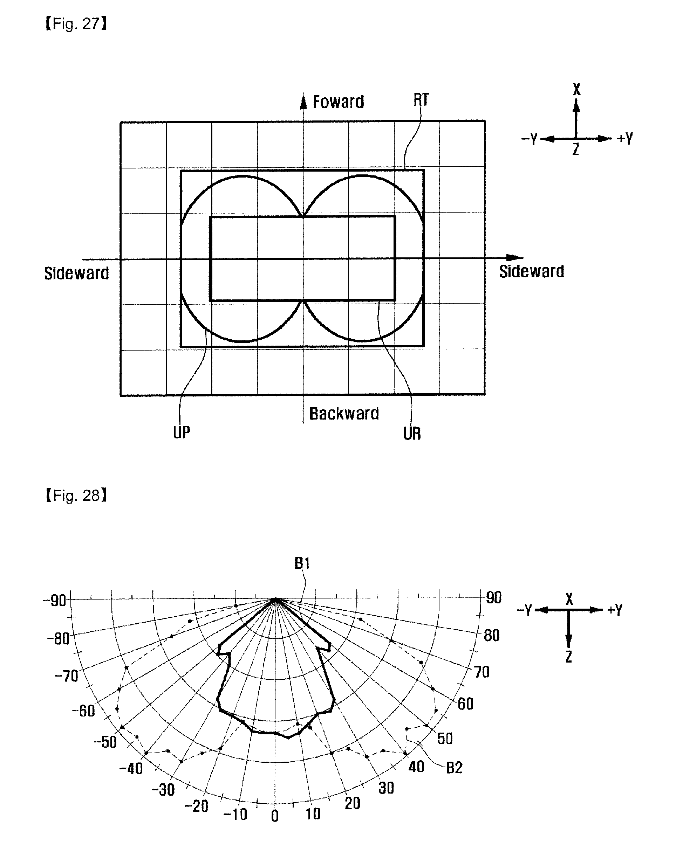

FIG. 27 is a view showing lamination distribution of a radiation surface according to an FTE calculator. Referring to FIG. 27, RT is Rectangular Target, UP is Uniform Pool, UR is Uniform Rectangle, Sideward is luminance distribution in +Y,-Y direction, Forward is luminance distribution in +X direction, and Backward is luminance distribution in -X direction. The simulation data to observe was based on luminance distribution of the radiation surface when all of the light sources were at a height of 10m, and in FIG. 27, the width of the lattices is 10m in both length and breadth. For example, when the Sideward is 2.5, it means the luminance distribution is a space within 25m in the +Y direction and 25m in the -Y direction. The simulation data was based on Unshielded in Outdoor Area & Parking Garage of Category A in Energy Star Standard, under assumption that the lighting device has luminaire output of around 9000 lm; therefore, in this case the FTE value (lm/W) for satisfying Energy Star should be 53. Input power of 120W was measured. In the embodiments, the larger the Uniform Rectangle UR, the ratio occupied by the Uniform Pool UP in the Rectangular Target RT (hereafter referred to as 'Coverd'), and the width of the Sideward in both Rectangular Target RT and Uniform Rectangular UR, the more the lighting device is efficient. Hereafter, the Coverd is described in detail. For example, assume that the maximum luminance value is 30 in the radiation region where light emitted from the lighting is radiated and the minimum luminance value is 1. The values 30 and 1 are not absolute values, but ratios of two values. Further, a region S1 where the luminance value is in the range of 1 to 30 is specified. Further, a region where the luminance value is 1 is excepted, when the average luminance value in the specified region S1 is more than 6, which is six times the minimum luminance value.

When the minimum luminance value is 1.1 after the region where the luminance value is 1 is excepted, the radiation region is a region S2 where the luminance value is in the range of 1.1 to 30. When it is determined that the average luminance value in S2 is less than 6.6, which is six times the minimum luminance value 1.1, S2 is specified as the Uniform Pool (UP). If it is more than 6.6, the above process is repeated until the average luminance value does not excess six times the minimum luminance value, and Sn is specified as the Uniform Pool (UP). A rectangle surrounding Sn specified as described above is Rectangular Target T. Consequently, Coverd represents (UP/RT)*100.

Although the simulation data was measured on the basis of the premise and values, required FTE value, Coverd, and efficient shape may be changed in accordance with the usage, installed height, input voltage, and output intensity of light of the lighting device. For example, the values used in the simulation is examples and may be measured on the basis of the Unshielded type in the FTE Calculator, and accordingly, the required FTE value may changes, such as 37, 48, and 70.

h1 was 1mm, h3 was 14.6mm, and D6 was 45mm in all of the experiments, but r was 24.64mm when the exit surface 145 was a spherical lens and r was 17mm when the exit surface was a non-spherical lens. A conic constant for a hyperbola was sued when the exit surface 145 was a non-spherical surface, and only $C_4, C_6$, and $C_8$, the non-spherical constants, were used, which is substantially meaningful to define the shape of the lens 140. In this case, the experiment was performed with $C_4$ of $-9.7407e^{-8}$, $C_6$ of $4.1275e^{-8}$, and $C_8$ of $-4.1969e^{-12}$.

In the experimental example 1, the exit surface 145 was a spherical lens shape without the furrow surface 141, in which Coverd was 76%, FTE (lm/W) was 53, Forward and Backward of FTE (Rectangular Target) were 1.9, Sideward was 2.6, Forward and Backward of FTE (Uniform Target) was 0.9, and Sideward was 2.0.

In the experimental example 2, the exit surface 145 was a spherical lens shape with the radius of curvature of the furrow surface 141 of 5mm and the width of the furrow surface 141 of 8mm, in which Coverd was 84%, FTE (lmM) was 58, Forward and Backward of FTE (Rectangular Target) were 1.7, Sideward was 2.6, Forward and Backward of FTE (Uniform Target) was 1.3, and Sideward was 2.1.

In the experimental example 3, the exit surface 145 was a non-spherical lens shape without the furrow surface 141, in which Coverd was 81%, FTE (lmM) was 55, Forward and Backward of FTE (Rectangular Target) were 1.8, Sideward was 2.5, Forward and Backward of FTE (Uniform Target) were 0.9, and Sideward was 2.0.

In the experimental example 4, the exit surface 145 was a non-spherical lens shape with the radius of curvature of the furrow surface 141 of 2mm and the width of the furrow surface 141 of 4mm, in which Coverd was 85%, FTE (lm/W) was 58, Forward and Backward of FTE (Rectangular Target) were 1.7, Sideward was 2.5, Forward and Backward of FTE (Uniform Target) was 1.3, and Sideward was 2.1.

In the experimental example 5, the exit surface 145 was a non-spherical lens shape with the radius of curvature of the furrow surface 141 of 5mm and the width of the furrow surface 141 of 8mm, in which Coverd was 88%, FTE (lm/W) was 60, Forward and Backward of FTE (Rectangular Target) were 1.6, Sideward was 2.5, Forward and Backward of FTE (Uniform Target) was 1.3, and Sideward was 2.1.

In the experimental example 6, the exit surface 145 was a non-spherical lens shape with the radius of curvature of the furrow surface 141 of 9.2mm and the width of the furrow surface 141 of 12mm, in which Coverd was 83%, FTE (lm/W) was 57, Forward and Backward of FTE (Rectangular Target) were 1.6, Sideward was 2.4, Forward and Backward of FTE (Uniform Target) was 1.2, and Sideward was 2.0.

In the experimental example 7, the exit surface 145 was a non-spherical lens shape with the radius of curvature of the furrow surface 141 of 12mm and the width of the furrow surface 141 of 16mm, in which Coverd was 89%, FTE (lm/W) was 61, Forward and Backward of FTE (Rectangular Target) were 1.4, Sideward was 2.1, Forward and Backward of FTE (Uniform Target) was 1.2, and Sideward was 1.7.

The exemplary embodiments are as the following Table 1.

Table 1

| | Radius of curvature/width of furrow surface (mm) | Shape of exit surface | Minimum width n X-axis direction at maximum luminance 10% | Maximum width n Y-axis direction at maximum luminance 10% | FTE (Rectangular Target) | | | | FTE (Uniform Rectangle) | | |
|---|---|---|---|---|---|---|---|---|---|---|---|
| | | | | | Forward | Sideward | Backward | Coverd (%) | Forward | Sideward | Backward |
| 1 | no | Spherical surface | 10 | 22 | 1.9 | 2.6 | 1.9 | 76 | 0.9 | 2.0 | 0.9 |
| 2 | 5/8 | Spherical surface | 11 | 22 | 1.7 | 2.6 | 1.7 | 84 | 1.3 | 2.1 | 1.3 |
| 3 | no | Non-spherical surface | 10 | 23 | 1.8 | 2.5 | 1.8 | 81 | 0.9 | 2.0 | 0.9 |
| 4 | 2/4 | Non-spherical surface | 12 | 23 | 1.7 | 2.5 | 1.7 | 85 | 1.3 | 2.1 | 1.3 |
| 5 | 5/8 | Non-spherical surface | 12 | 23 | 1.6 | 2.5 | 1.6 | 88 | 1.3 | 2.1 | 1.3 |
| 6 | 9.2/12 | Non-spherical surface | 14 | 23 | 1.6 | 2.4 | 1.6 | 83 | 1.2 | 2.0 | 1.2 |
| 7 | 12/16 | Non-spherical surface | 15 | 20 | 1.4 | 2.1 | 1.4 | 89 | 1.2 | 1.7 | 1.2 |

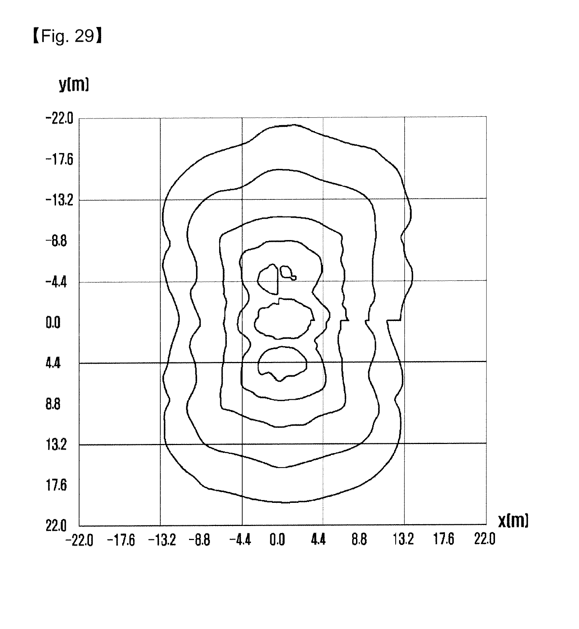

FIG. 28 is a view showing light distribution in a space by a lighting unit 100 using the lens 140 of the experimental example 5 and FIG. 29 is a view showing light distribution in a space by a lighting unit 100 using the lens 140 of the experimental example 5. Referring to FIG. 28, light distribution when the lighting unit 100 is seen from the front in the X direction is shown as B2 and light distribution when the lighting unit 100 is seen from the front in the Y direction is shown as B1. Referring to FIG. 29, it can be seen that the luminance distribution in the Y-axis direction is considerably wider than the luminance distribution in the X-axis direction and an approximate rectangle. Comparing FIG. 28 with FIG. 25, it can be seen that the center portion of the radiation surface is lack of light and not dark in both FIG. 28 and FIG. 25, but there is excessive light at the center portion relatively to the interface region of light, such that light is not uniformly distributed over the entire radiation surface in FIG. 25. On the other hand, it can be seen that light is less at the center portion of FIG. 28 than FIG. 25, such that luminance distribution is uniform over the entire radiation surface.

Considering the data of FIG. 28, FIG. 29, and the experimental example seen above, the experimental example is the most efficient in the above experimental examples. In the experimental example 5, Sideward of FTE (Rectangular Target) is 2.5, Sideward of FTE (Uniform Target) is 2.1, which is a high level in the experimental example, Coverd is 88%, which is the highest level, and FTE(lm/W) is 60 which is highest level. Therefore, it will be preferable to use the lens 140 having the values of the experimental example 5.

However, the factors for evaluating the efficiency of the lens 140 are various, such as the width of Sideward, Coverd, FTE (lm/M) value, as described above, and the experimental example 5 is not absolutely excellent in all of the factors. Therefore, any one of the width of Sideward, Coverd, FTE (lm/W) value may be important in real use of a lighting device, in which the lens of the other experimental examples than the experimental example 5 or the lenses 140 other than those of the experimental example 2 and the experimental example 4 to the experimental example 7 may show more excellent efficiency. However, in the lighting device 100 used for street lamps and outdoor lamps in external lamps, it is clear that the lighting unit 100 equipped with the lens 140, in which the exit surface 145 has a spherical or a non-spherical, the incident surface 143 has the prism surface 142 and the furrow surface 141, and the width of the furrow surface 141 is 9% ~40% of the diameter of the incident side, has higher efficiency than common lighting devices, and the lenses 140 having these features should be considered as being included in the spirit of the present invention. Further, the lighting device 100 that preferably shows luminance equipped with the lenses 140 of the experimental examples and other equivalent lenses 140. Embodiment of Lighting Unit Using Lens Having Spherical or Non-Spherical Exit Surface and Incident Surface with Furrow Surface and Prism Surface.

Those as second to fifth embodiments described examples are not covered by the present invention.

FIG. 30 is a side cross-sectional view showing a lighting unit 100A according to a second embodiment. In the description of the second embodiment, the first embodiment is referred for the same components as those in the first embodiment and the repeated description is omitted.

Referring to FIG. 30, a lighting unit 100A includes a light emitting unit 101, a lens 140, and a gap member 130. The gap member 130 may be made of epoxy or silicon resin in a ring shape, and is in contact with the edge of the upper surface of the substrate 110 of the light emitting unit 101 and the bottom of the flange 144 of the lens 140. Therefore, it is disposed between the substrate 110 and the lens 140 to space the substrate 110 and the lens 140 by a predetermined gap G1. The space3 105 defined by the gap member 130 can improve light directional distribution of the LEDs 120 of the light emitting unit 101.

Meanwhile, fluorescent substances may be added to the gap member, if needed. Further, the upper surface of the substrate 110 of the light emitting unit 101 may be coated with a reflective substance to reflect light traveling to the substrate 110.

FIG. 31 is a side cross-sectional view showing a lighting unit 100B according to a third embodiment. In the description of the third embodiment, the first embodiment is referred for the same components as those in the first embodiment and the repeated description is omitted.

Referring to FIG. 31, in the lighting unit 100B, the flange 144A, which protrudes downward to the light emitting unit 101, of the lens 140 replaces the gap member 130. The flange 144A of the lens 140 can be disposed to contact the edge of the upper surface of the substrate 110 of the light emitting unit 101, or to contact both the outer circumference of the substrate 110 and the edge of the upper surface of the substrate 110 of the light emitting unit 101.

The flange 144A of the lens 140 spaces the substrate 110 of the light emitting unit 101 and the lens 140 by a predetermined gap G1.

The space 105 between the light emitting unit 101 and the lens 140 may be filled with resin, such as silicon or epoxy, and fluorescent substances may be added to the resin.

The substrate 110 of the light emitting unit 101 is disposed under the flange 144A of the lens 140 and the lens flange 144a is stepped with respect to the incident surface 143. According to another example, a protrusion may be formed around the outer circumference of the upper surface of the substrate to maintain the gap between the substrate 110 and the lens 140.

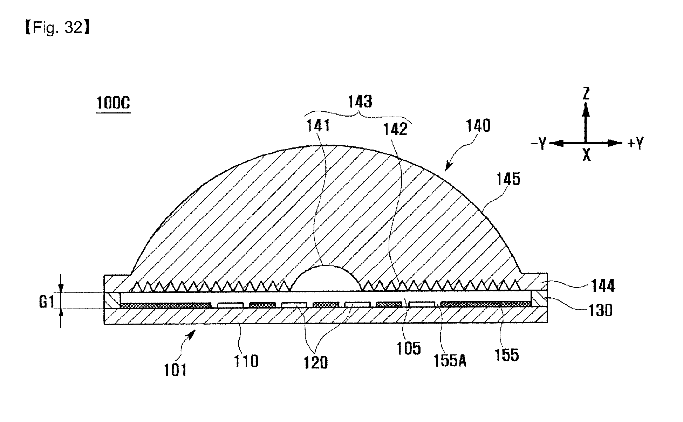

FIG. 32 is a side cross-sectional view showing a lighting unit 100C according to a fourth embodiment. In the description of the fourth embodiment, the first embodiment is referred for the same components as those in the first embodiment and the repeated description is omitted.

Referring to FIG. 32, a reflective plate 155 is disposed on the substrate 110 of the light emitting unit 101. The reflective plate has LED holes 155A not to cover the LEDs 120 while covers the regions where the LEDs 120 are not exposed on the substrate 110. Therefore, some of the light emitted from the LEDs 120 can be reflected from the reflective plate 155, such that the amount of reflected light increases and light efficiency is improved. The reflective plate 155 is not necessarily a separate member from the substrate 110 and the upper surface of the substrate 110 may replace the reflective plate 155 by increasing reflective ratio of the upper surface of the substrate 110. Further, a diffusion material may be applied to the upper surface of the reflective plate 155.

The gap member 130 is disposed between the substrate 110 and the flange 144 of the lens 140 to space the substrate 110 and the lens 140 by a predetermined gap G1. The space 105 is defined between the lens 140 and the substrate 110, light emitted from the LEDs 120 is diffused in the space 105 between the substrate 110 and the lens 120, and the diffused light can be diffused through the prism surface 142 and the furrow surface 141 of the lens 140.

Meanwhile, the other configuration is the same as the fourth embodiment shown in FIG. 32 the gap member 130 described in the first embodiment may replace the gap member 130 of the fourth embodiment, which is a fifth embodiment (not shown). In the fifth embodiment, both voltage resistance and light efficiency are improved in the same was as the effect of the gap member 130 described in the first embodiment, and the reflective plate 155 used in the fourth embodiment is used, such that the light efficiency can be more improved.

A lighting device including the lighting unit 100 is described hereafter.

Lighting Device Including Lighting Unit

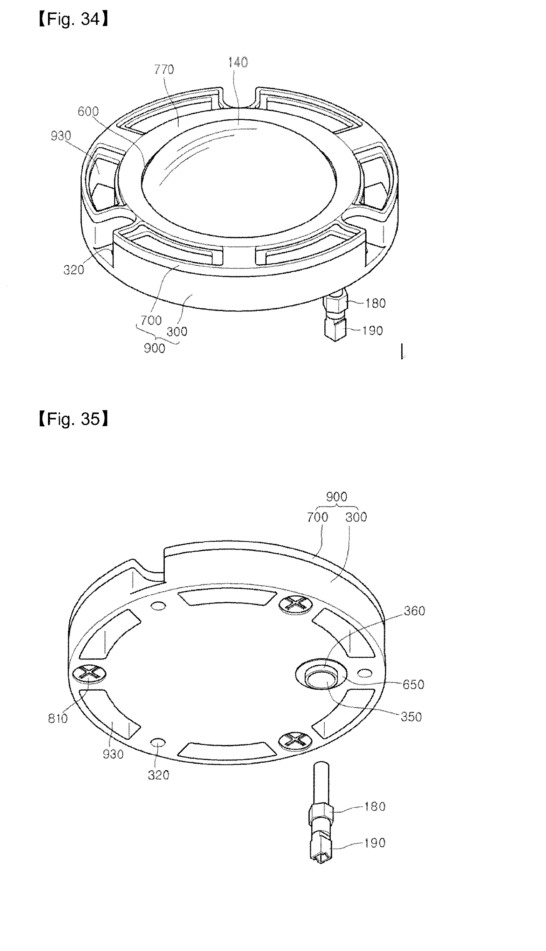

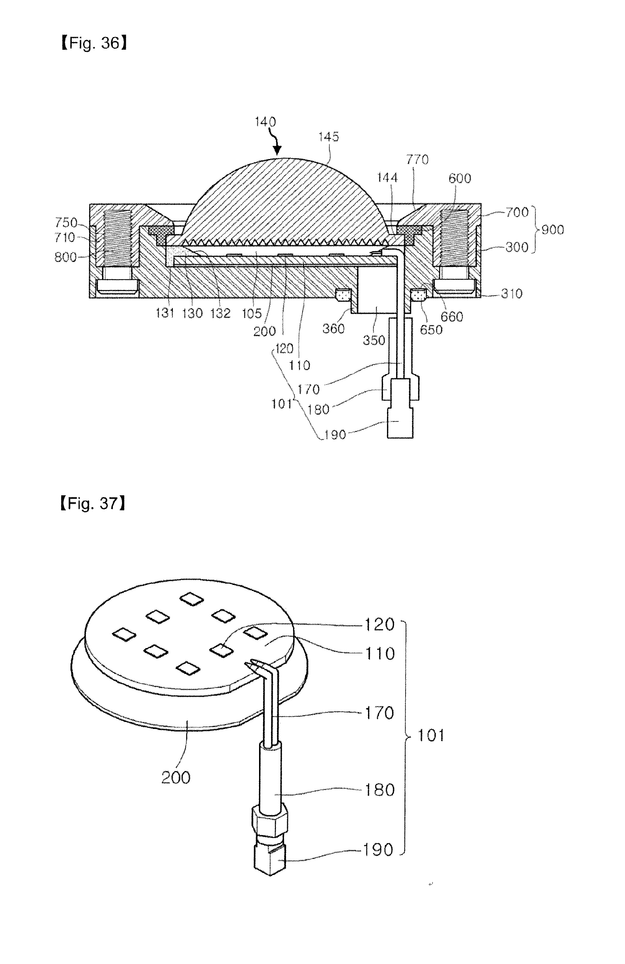

FIG. 33 is an exploded perspective view of a lighting device according to a sixth embodiment, FIG. 34 is a perspective view of a lighting device according to the sixth embodiment, seen from above, FIG. 35 is a perspective view of the lighting device according to the sixth embodiment, seen from below, and FIG. 36 is cross-sectional view of the lighting device according to the sixth embodiment FIG. 37 is a view showing a light emitting unit of the lighting device. Referring to FIGS. 33 to 36, a lighting device 10 according to the sixth embodiment includes a case body 300, a heat dissipation plate 200 in an inner groove of the case body 300, a light emitting unit 101 on the heat dissipation plate 200, a gap member 130 on the light emitting unit 101, a lens 140 on the gap member 130, a first waterproof ring 600 on the flange 144 of the lens 140, and a case cover 700 on the first waterproof ring 600 and the case body 300.

The case body 300 and the case cover 700 are combined and fixed by screws to form the case 900 of the lighting device.

The heat dissipation plate 200 dissipates heat generated from the light emitting unit 101.

The light emitting unit 101 may include a substrate 110, a plurality of LEDs 120 mounted on the substrate 110, and a lead electrode 170 transmitting power to the LEDs 120.

The lead electrode 170 is partially exposed to the outside through a through-hole 350 formed through the bottom of the case body 300 to be electrically connected with an external power source.

A protective tube 180 may be provided to cover the exposed portion of the lead electrode 170, in order to protect the exposed lead electrode 170 from the external environment, such as heat and humidity, and a connecting terminal 190 is formed at the lower end of the lead electrode 170 such that the lead electrode 170 is connected to the external power source through the connecting terminal 190.

The lens 140 makes it possible to achieve desired discharge light distribution by adjusting the light generated from the light emitting unit 101.

The gap member 130 makes a space between the lens 140 and the light emitting unit 101 by spacing the light emitting unit and the lens 140 by a predetermined gap G1, such that it is possible to induce desired light emitting angle and light diffusion.

The first waterproof ring 600 is disposed between the case cover 700 and the lens 400 to prevent water from flowing into the lighting device 10.

Meanwhile, a second waterproof ring 650 may be formed on the outer circumference of the through-hole 350 on the bottom of the case body 300 to prevent water from flowing inside through the through-holes 350 when the lighting device 10 is attached to an external support member.

Sixth Embodiment

Hereafter, the lighting device 10 according to the sixth embodiment, mainly the components, are described in detail.

Referring to FIGS. 33 to 36, the case body 300 may have a circular body with a space therein, that is, an inner groove. Further, the case cover 700 is shaped to correspond to the case body 300, having a circular ring shape with an opening.

The case body 300 and the case cover 700 are combined, such that the case 900 is formed. The case 900 forms the body of the lighting device 10 and accommodates the heat dissipation plate 200, the light emitting unit 101, the gap member 130, the lens 140, and the first waterproof ring 600 etc.

That is, the heat dissipation plate 200 is dispose in the space of the case body 300, that is, in the inner groove, the light emitting unit 101 is disposed on the heat dissipation plate 200, the gap member 130 is disposed on the edge of the light emitting unit 101, the lens 140 is disposed on the gap member 130, the first waterproof ring 600 is disposed on the flange 144 of the lens 140, and the case cover 700 is disposed on the first waterproof ring 600 and the case body 300. In this configuration, the lens 140 is exposed through the opening of the case cover 700.

Meanwhile, the shape of the case 900, that is, the shapes of the case body 300 and the case cover 700 are not limited to the circle and may be modified in various ways.

The case 900 is preferably made of a material having good heat dissipation properties, that is, metal, for example one of aluminum (Al), nickel (Ni), copper (Cu), silver (Au), and tin (Sin). Further, the surface of the case 900 may be plated. Alternatively, the case 900 may be made of resin.

The circumference of the case body 300 has an inner wall and an outer wall, and first hole 310, a second hole 320, and a first heat dissipation hole 330 may be formed between the inner wall and the outer wall.

Further, the circumference of the case cover 700 also has an inner wall and an outer wall, and a protrusion 710 and a second heat dissipation hole 730 may be formed between the inner wall and the outer wall.

In this configuration, the outer walls of the circumferences of the case body 300 and the case cover 700 may not be formed where the second hole 320 is formed.

Referring to FIG. 36, the protrusion 710 may have a screw groove 750 and is inserted in the first hole 310, the screw 800 is inserted in the screw groove 750 and the first hole 310, such that the case body 300 and the case cover 700 can be firmly combined and fixed.

The screw 800 may be inserted, with the head down, into the screw groove 750 of the protrusion 710 of the case cover 700 through the first hole 310 of the case body 300. Since the screw 800 is inserted through the first hole 310, the screw 800 is not exposed on the upper surface of the case cover 700. However, the insertion of the screw 800 may be modified in various ways.

As described above, since the case 900 can be combined or separated by the screws 800, when a fault occurs in the lighting device 10, the maintenance can be easily performed by inserting or removing the screws 800.

It is possible to fasten the lighting device 100 to a desired external support member, such as a street lamp or a vehicle lamp, by inserting a screw into the second hole 320 of the case body 300. In this configuration, the outer walls may not be formed where the second hole 320 is formed, in the circumferences of the case body 300 and the case cover 700, as described above, to easily insert the screw into the second hole 320.

The heat dissipation hole 930 of the case 900 is formed by the first heat dissipation hole 330 of the case body 300 and the second heat dissipation hole 730 of the case cover 700. The surface area of the case 900 is increased by the heat dissipation hole 930, such that the heat generated from the light emitting unit 101 can be effectively discharged, and the weight of the lighting device can be reduce as compared with when the heat dissipation hole 930 is not formed.

Referring to FIG. 35 and FIG. 36, the through-hole 350 may be formed through the bottom of the case body 300. A portion of the lead electrode 170 of the light emitting unit 101 is exposed to the outside through the through-hole 350 and connected to the external power source.

The through-hole 350 is formed such that the circumference 360 protrudes from the bottom of the case body 300. Since the circumference 360 of the through-hole 350 protrudes, the lighting device 10 can be accurately mounted to an external support member.

Further, the second waterproof ring 650 may be fitted around the outer circumference of the through-hole 360. The second waterproof ring 650 improves reliability of the lighting device 10 by prevent water from flowing into the lighting device 10 through the through-hole 350, when the lighting device 10 is attached to an external support member.

In this configuration, a ring groove 660 corresponding to the shape of the second waterproof ring 650 may be formed around the outer circumference of the circumference 360 of the through-hole 350.

Referring to FIGS. 33, 34, and 36, the inner side 770 of the case cover 700 may be inclined and accordingly the light emitted through the lens 140 can be effectively discharged. Further, the inner side 770 of the case cover 700 fixes the heat dissipation plate 200, the light emitting unit 101, the gap member 130, the lens 140, and the first waterproof ring 600 inside the case 900.

FIG. 37 shows the light emitting unit 101.

Referring to FIG. 33 and FIG. 37, the light emitting unit 101 may include a substrate 110, a plurality of LEDs 120 mounted on the substrate 110, and a lead electrode 170 transmitting power to the LEDs 120. The light emitting unit 101 supplies light to the lighting device 10.

The light emitting unit 101 is shaped to correspond to the shape of the inner groove of the case 900 to be accommodated in the case 900, in the circular plate, as shown in the figures, but is not limited thereto.

The substrate is an insulating member with a circuit printed and may be an aluminum substrate, a ceramic substrate, a metal core PCB, and a common PCB etc.

A color that efficiently reflects light, for example, white may be applied to the surface of the substrate 110.

The LEDs 120 may be mounted in an array on the substrate 110 and the arrangement and number of the LEDs 120 may be modified in various ways, if needed.

The LEDs 120 may be light emitting diodes. As the light emitting diodes, red LEDs, blue LEDs, green LEDs, and white LEDs may be selectively used and various other arrangements can be used.

The lead electrode 170 has one end connected to the substrate 110 and the other end exposed to the outside through the through-hole 350 formed through the bottom of the case body 300 to be electrically connected with an external power source.

A protective tube 180 may be provided to cover the other end of the lead electrode 170, in order to protect the exposed lead electrode 170 from the external environment, such as heat and humidity, and a connecting terminal 190 is formed at the other end of the lead electrode 170 such that the lead electrode 170 is connected to the external power source through the connecting terminal 190.

Meanwhile, the substrate 110 may be further provided with a DC converter that converts alternating current into direct current supply it, or a protective element that protects the lighting device 10 from electrostatic discharge or surge.

The heat dissipation plate 200 may be attached to the bottom of the light emitting unit 101. The heat dissipation plate 200 can discharge the heat generated from the light emitting unit 101 to the outside of the case 900.

The heat dissipation plate 200 is made of a thermal conductive material, and for example, may be any one a thermal conductive silicon pad or a thermal conductive tape.

The lens 140 has the exit surface 145 and the flange 144. The exit surface 145 adjusts discharge light distribution of the light generated from the light emitting unit 101 and discharges the light. The exit surface 145 is exposed through the opening of the case cover 700, such that the light can be discharged.

The flange 144 may be formed in a circular ring shape around the bottom of the exit surface 145 and the first waterproof ring 600 is dispose on the flange 144.

The lens 140 may be formed by injection-molding a light transmissive material, and the material may be glass and plastic, such as PMMA (Poly methyl methacrylate) and PC (Polycarbonate). Although the lens 140 is shown in a semi-spherical shape, all of the lenses 140 having various shapes described above can be used in the lighting device 10.

Further, the lens 140 can be easily replaced by a lens having desired discharge light distribution by separating the case body 300 from the case cover 700. Therefore, the lighting device can be used for various purposes.

The first waterproof ring 600 is disposed on the flange 144 of the lens 140.

Referring to FIG. 36, the first waterproof ring 600 may be formed in a circular ring shape to cover the upper surface and the circumference of the flange 144. That is, as shown in the figure, the first waterproof ring 600 may be disposed between the flange 144 of the lens 140 and the inner side 770 of the case cover 700.

The first waterproof ring 600 may be made a waterproof material, for example, waterproof rubber or waterproof silicon.

The first waterproof ring 600 fills the space between the lens 140 and the case cover 700 while covering the upper surface and the circumference of the flange 144, such that water cannot flow into the lighting device through the space and the reliability of the lighting device is improved.

Referring to FIG. 35 and FIG. 36, the second waterproof ring 650 may be disposed around the outer circumference of the circumference of the through-hole 350 formed through the bottom of the case body 300. The second waterproof ring 650 improves reliability of the lighting device 10 by prevent water from flowing into the lighting device 10 through the through-hole 350, when the lighting device 10 is attached to an external support member.

In this configuration, the ring groove 660 may be formed around the outer circumference of the circumference 360 of the through-hole 350.

The second waterproof ring 650 may be made a waterproof material, for example, waterproof rubber or waterproof silicon.

Seventh Embodiment

Hereafter, the lighting device 10 according to the seventh embodiment, mainly the components, are described in detail. In the description of the seventh embodiment, the sixth embodiment is referred for the same components as those in the sixth embodiment and the repeated description is omitted.

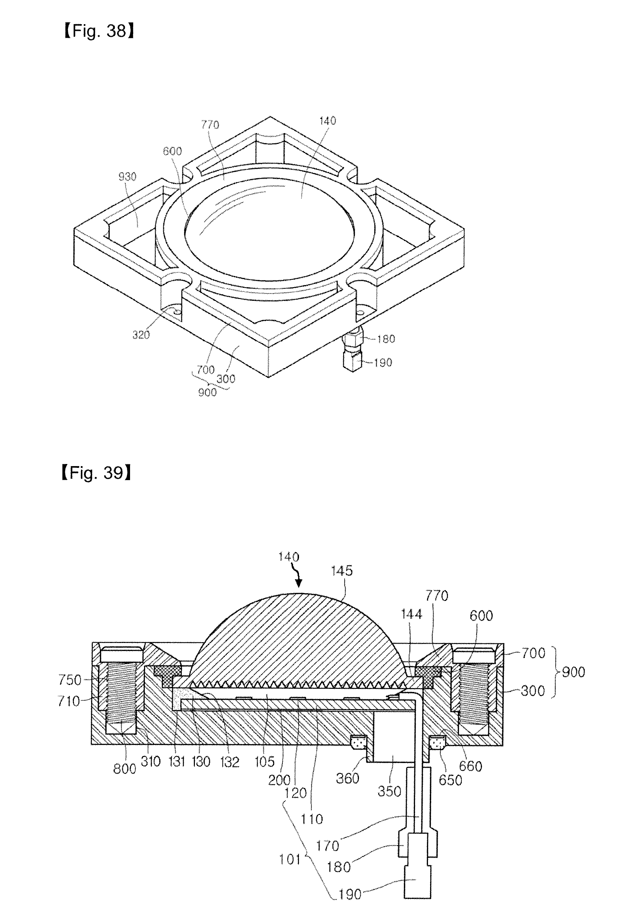

FIG. 38 is a perspective view of a lighting device according to a seventh embodiment, seen from above. Referring to FIG. 38, the case body 300 has a rectangular body having a space, that is, an inner groove. Further, the case cover 700 is formed in a rectangular ring shape, corresponding to the shape of the case body 300.

The case body 300 and the case cover 700 are combined, such that the case 900 having the rectangular shape is formed. The case 900 forms the body of the lighting device 10 and accommodates the heat dissipation plate 200, the light emitting unit 101, the gap member 130, the lens 140, and the first waterproof ring 600 etc.

That is, the case 900 can be modified in various shapes within the scope of the present invention. For example, the shape of the case 900 may be a circle, a rectangle, a polygon, and an ellipse.

Eighth Embodiment

Hereafter, the lighting device according to the eighth embodiment, mainly the components, are described in detail. In the description of the eighth embodiment, the sixth embodiment is referred for the same components as those in the sixth embodiment and the repeated description is omitted.

FIG. 39 is cross-sectional view of a lighting device according to the eighth embodiment.

Referring to FIG. 39, the circumference of the case body 300 has an inner wall and an outer wall, and a first hole 310, a second hole (not show), and a first heat dissipation hole (not shown) may be formed between the inner wall and the outer wall.

Further, the circumference of the case cover 700 also has an inner wall and an outer wall, and a protrusion 710 and a second heat dissipation hole (not shown) may be formed between the inner wall and the outer wall.

Referring to FIG. 39, the protrusion 710 may have a screw hole 750 and is inserted in the first hole 310, the screw 800 is inserted in the screw hole 750 and the first hole 310, such that the case body 300 and the case cover 700 can be firmly combined and fixed.

The screw 800 may be inserted, with the head up, into the first hole 310 of the case body 300 through the screw hole 750 of the protrusion 710 of the case cover 700. As described above, the screw 800 is exposed on the upper surface of the case cover 700 by inserting the screw 800 through the screw hole 750, such that the screw 800 can be easily inserted or removed.

Therefore, when a fault occurs in the lighting device 10, the maintenance is easily performed by inserting or removing the screw 800.

Meanwhile, the method of combining and fixing the case cover 700 and the case body 300 is not limited to the sixth embodiment and the eighth embodiment and may be modified in various ways.

Ninth Embodiment

Hereafter, the lighting device 10 according to the ninth embodiment, mainly the components, are described in detail. In the description of the ninth embodiment, the sixth embodiment is referred for the same components as those in the sixth embodiment and the repeated description is omitted.

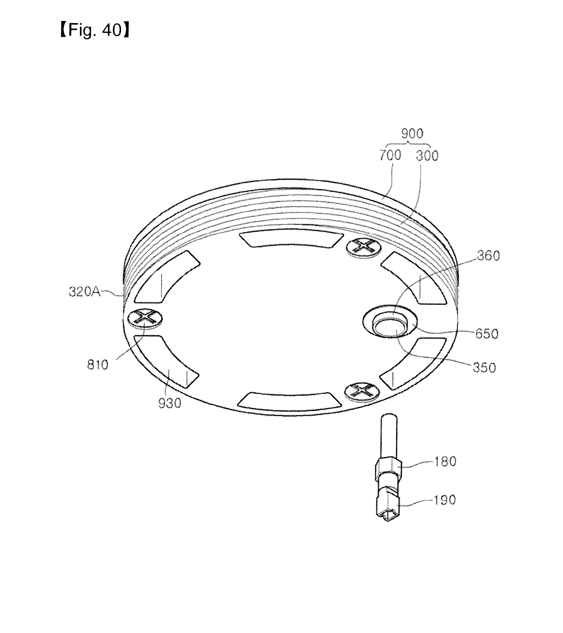

FIG. 40 is a cross-sectional view of a lighting device according to the ninth embodiment.

Referring to FIG. 40, the case body 300 has a body having a space, that is, an inner groove. Further, the case cover 700 is formed in a ring shape, corresponding to the shape of the case body 300.

The case body 300 and the case cover 700 are combined, such that the case 900 is formed. The case 900 forms the body of the lighting device 10 and accommodates the heat dissipation plate 200, the light emitting unit 101, the gap member 130, the lens 140, and the first waterproof ring 600 etc.

Meanwhile, in the ninth embodiment, a thread 320A is formed on the circumference of the case 900, instead of the second hole 320 formed to attach the lighting device 100 to a wall etc. in the sixth embodiment. The lighting device can be fastened to an external support member, such as a wall, a street lamp, and a vehicle, if needed, by the thread 320A.

That is, a threaded groove (not shown) corresponding to the thread (320A) may be formed where the lighting device is attached to an external support member, such as a wall, a street lamp, and a vehicle, such that the lighting device 10 can be attached to the external support member, such as a wall, a street lamp, and a vehicle, by fitting the thread 320A into the threaded groove (not shown).

Therefore, it is possible to attach the lighting device 10 to the external support member, such as a wall, a street lamp, and a vehicle, without using a screw.

Meanwhile, the method of attaching the lighting device 10 to the external support member, such as a wall, a street lamp, and a vehicle, is not limited to the methods described in the sixth embodiment and the ninth embodiment, and may be modified in various ways.

Although preferred embodiments of the present invention were described above, theses are just examples and do not limit the present invention. Further, the present invention may be changed and modified in various ways, without departing from the essential features of the present invention, by those skilled in the art. For example, the components described in detail in the embodiments of the present invention may be modified. Further, differences due to the modification and application should be construed as being included in the scope and spirit of the present invention, which is described in the accompanying claims.

**Claims**

1. A lighting device comprising:

   a light emitting unit (101) comprising a circular substrate (110) and a plurality of light emitting devices (120) disposed on the substrate (110);
   a lens (140) disposed on the light emitting unit (101); and
   a ring-shaped gap member (130) disposed between the lens (140) and the light emitting unit (101) and spacing the substrate (110) and the lens (140) by a predetermined gap (G1),
   wherein the gap member (130) comprises:

      a ring-shaped wall (131); and
      a reflective portion (132) having an circular opening (133) and extended at a predetermined inclination from an upper surface of the wall (131) toward the center of the opening (133),

   wherein the light emitting devices (120) are exposed through the opening (133),
   wherein the gap member (130) is disposed on the substrate (110),
   wherein the diameter (D1) of the substrate (110) is greater than the diameter (D2) of the opening (133),
   wherein the substrate (110) is accommodated under the gap member (130), wherein the bottom surface of the reflective portion (132) is in contact with the edge of the upper surface of the substrate (110), and wherein an inner circumference of the ring-shaped wall (131) is in contact with an outer circumference of the substrate (110) such that the light emitting unit is seated in the gap member.

2. The lighting device of claim 1, wherein the substrate (110) comprises a flat portion (114), wherein the gap member (130) comprises a flat portion (134), and wherein the flat portion (114) of the substrate (110) and the flat portion (134) of the gap member (130) are in contact with each other.

3. The lighting device of claim 1 or claim 2, wherein the light emitting unit (101) further comprises a lead electrode (170) transmitting power to the light emitting devices (120), and wherein the gap member further comprises an electrode-through portion (135) through which the lead electrode (170) passes.

4. The lighting device of any one claim of claims 1 to 3, wherein the light emitting unit (101) further comprises a reflective plate (155) disposed on the substrate (110).

5. The lighting device of any one claim of claims 1 to 4, further comprising a case (900), wherein the case (900) comprises:

   a case body (300) having a circular body with a space accommodating the light emitting unit (101), the gap member (130) and the lens (140); and
   a case cover (700) disposed on the case body (300) and having a circular ring shape with an opening, and wherein the lens (140) comprises a spherical exit surface (145) and a flange (144) disposed around a bottom of the exit surface (145),
   wherein the exit surface (145) of the lens (140) is disposed in the opening of the case cover (700).

6. The lighting device of claim 5, wherein case (900) has a heat dissipation hole (930), wherein the case body (300) has a first heat dissipation hole (330), wherein the case cover (700) has a second heat dissipation hole (730), and wherein the heat dissipation hole (930) is formed by the first heat dissipation hole (330) and the second heat dissipation hole (730).

7. The lighting device of claim 5 or claim 6, wherein the case cover (700) comprises an inner side (770) extended at a predetermined inclination from an upper surface of the case cover (700) toward the center of the opening of the case cover (700).

8. The lighting device of claim 7, further comprising a waterproof ring (600) disposed between the inner side (770) of the case cover (700) and the flange (144) of the lens (140).

9. The lighting device of claim 8, wherein the waterproof ring (600) covers an upper surface and a circumference of the flange (144).

10. The lighting device of any one claim of claims 5 to 9, wherein the case body (300) comprises a thread (320A) disposed on a circumference of the case body (300).

11. The lighting device of any one claim of claims 1 to 4, wherein the lens comprising:

a circular incident surface (143) adapted to receive light from the light emitting unit and being perpendicular to an incident light axis, the incident surface comprising an elongated groove (141) extending along a diameter of the circular surface and having a width between 9% and 40% of the diameter of the incident surface, and prism surfaces (142) formed on both sides of the elongated groove, the prism surfaces comprising a plurality of elongated prisms extending in a direction parallel to the elongated groove;
a hemispherical exit surface (145) that refracts and transmits light travelling through the incident surface to the outside of the lens; and
a circular flange (144) that is formed around the circumference of the incident surface.

**Patentansprüche**

1. Beleuchtungsvorrichtung mit:

einer lichtemittierenden Einheit (101), die ein kreisförmiges Substrat (110) und mehrere an dem Substrat (110) angeordnete lichtemittierende Vorrichtungen (120) aufweist;
einer an der lichtemittierenden Einheit (101) angeordneten Linse (140); und
einem ringförmigen Abstandselement (130), das zwischen der Linse (140) und der lichtemittierenden Einheit (101) angeordnet ist und das Substrat (110) und die Linse (140) in einem vorgegebenen Abstand (G1) anordnet, wobei das Abstandselement (130) aufweist:

eine ringförmige Wand (131); und
einen reflektierenden Abschnitt (132), der eine kreisförmige Öffnung (133) hat und sich in einer vorgegebenen Neigung von der oberen Oberfläche der Wand (131) zum Zentrum der Öffnung (133) erstreckt,

wobei:

die lichtemittierenden Vorrichtungen (120) durch die Öffnung (133) hindurch freiliegen,
das Abstandselement (130) an dem Substrat (110) angeordnet ist,
der Durchmesser (D1) des Substrats (110) größer ist als der Durchmesser (D2) der Öff-nung (133),
das Substrat (110) unterhalb des Abstandselements (130) angeordnet ist, wobei die untere Oberfläche des reflektierenden Abschnitts (132) in Kontakt mit der Kante der oberen Oberfläche des Substrats (110) ist und wobei ein Innenumfang der ringförmigen Wand (131) in Kontakt mit einem Außenumfang des Substrats (110) ist, derart, dass die lichtemittierende Einheit in dem Abstandselement sitzt.

2. Beleuchtungsvorrichtung nach Anspruch 1, wobei das Substrat (110) einen ebenen Abschnitt (114) aufweist und das Abstandselement (130) einen ebenen Abschnitt (134) aufweist, wobei der ebene Abschnitt (114) des Substrats (110) und der ebene Abschnitt (134) des Abstandselements (130) in Kontakt miteinander sind.

3. Beleuchtungsvorrichtung nach Anspruch 1 oder 2, wobei die lichtemittierende Einheit (101) außerdem eine Leitungselektrode (170) aufweist, die den lichtemittierenden Vorrichtungen (120) Energie zuführt, und wobei das Abstandselement außerdem einen Elektrodendurchlassabschnitt (135) aufweist, durch welchen die Leitungselektrode (170) hindurchgeht.

4. Beleuchtungsvorrichtung nach einem der Ansprüche 1 bis 3, wobei die lichtemittierende Einheit (101) außerdem eine an dem Substrat (110) angeordnete reflektierende Platte (155) aufweist.

5. Beleuchtungsvorrichtung nach einem der Ansprüche 1 bis 4, ferner mit einem Gehäuse (900), wobei das Gehäuse (900) aufweist:

einen Gehäusekörper (300), der einen kreisförmigen Körper mit einem Raum hat, in welchem die lichtemittierende Einheit (101), das Abstandselement (130) und die Linse (140) untergebracht sind; und
eine Gehäuseabdeckung (700), die an dem Gehäusekörper (300) angeordnet ist und eine Kreisringform mit einer Öffnung hat, und

wobei die Linse (140) eine kugelförmige Austrittsfläche (145) und einen um einen Boden der Austrittsfläche (145) herum angeordneten Flansch (144) aufweist,

wobei die Austrittsfläche (145) der Linse (140) in der Öffnung der Gehäuseabdeckung (700) angeordnet ist.

6. Beleuchtungsvorrichtung nach Anspruch 5, wobei das Gehäuse (900) ein Wärmedissipationsloch (930) hat, wobei der Gehäusekörper (300) ein erstes Wärmedissipationsloch (330) hat und die Gehäuseabdeckung (700) ein zweites Wärmedissipationsloch (730) hat, und wobei das Wärmedissipationsloch (930) von dem ersten Wärmedissipationsloch (330) und dem zweiten Wärmedissipationsloch (730) gebildet wird.

7. Beleuchtungsvorrichtung nach Anspruch 5 oder 6, wobei die Gehäuseabdeckung (700) eine Innenseite (770) aufweist, die sich in einer vorgegebenen Neigung von einer oberen Oberfläche der Gehäuseabdeckung (700) zum Zentrum der Öffnung der Gehäuseabdeckung (700) erstreckt.

8. Beleuchtungsvorrichtung nach Anspruch 7, ferner mit einem wasserdichten Ring (600), der zwischen der Innenseite (770) der Gehäuseabdeckung (700) und dem Flansch (144) der Linse (140) angeordnet ist.

9. Beleuchtungsvorrichtung nach Anspruch 8, wobei der wasserdichte Ring (600) eine obere Oberfläche und einen Umfang des Flansches (144) bedeckt.

10. Beleuchtungsvorrichtung nach einem der Ansprüche 5 bis 9, wobei der Gehäusekörper (300) ein an einem Umfang des Gehäusekörpers (300) angeordnetes Gewinde (320A) aufweist.

11. Beleuchtungsvorrichtung nach einem der Ansprüche 1 bis 4, wobei die Linse aufweist:

eine kreisförmige Eintrittsfläche (143), die Licht von der lichtemittierenden Einheit empfangen kann und senkrecht zu einer Achse des eintretenden Lichts ist, wobei die Eintrittsfläche aufweist: eine längliche Rille (141), die sich entlang eines Durchmessers der kreisförmigen Fläche erstreckt und eine Breite zwischen 9% und 40% des Durchmessers der Eintrittsfläche hat, und Prisma-Oberflächen (142), die beiderseits der länglichen Rille gebildet sind, wobei die Prisma-Oberflächen mehrere längliche Prismen aufweisen, die sich in eine Richtung parallel zur länglichen Rille erstrecken;

eine halbkugelförmige Austrittsfläche (145), die Licht, das durch die Eintrittsfläche hindurchgegangen ist, einer Brechung unterwirft und es aus der Linse heraus leitet; und

einen kreisförmigen Flansch (144), der um den Umfang der Eintrittsfläche gebildet ist.

**Revendications**

1. Dispositif d'éclairage, comprenant :

une unité d'émission de lumière (101) comprenant un substrat circulaire (110) et une pluralité de dispositifs électroluminescents (120) disposés sur le substrat (110) ;

une lentille (140) disposée sur l'unité d'émission de lumière (101) ; et

un organe d'espacement de forme annulaire (130) disposé entre la lentille (140) et l'unité d'émission de lumière (101) et espaçant le substrat (110) et la lentille (140) d'un espacement prédéterminé (G1),

dans lequel l'organe d'espacement (130) comprend :

une paroi de forme annulaire (131) ; et

une portion réfléchissante (132) ayant une ouverture circulaire (133) et étendue à une inclinaison prédéterminée par rapport à une surface supérieure de la paroi (131) vers le centre de l'ouverture (133),

dans lequel les dispositifs électroluminescents (120) sont exposés à travers l'ouverture (133),

dans lequel l'organe d'espacement (130) est disposé sur le substrat (110),

dans lequel le diamètre (D1) du substrat (110) est supérieur au diamètre (D2) de l'ouverture (133),

dans lequel le substrat (110) est logé sous l'organe d'espacement (130), dans lequel la surface inférieure de la portion réfléchissante (132) est en contact avec le bord de la surface supérieure du substrat (110), et dans lequel une circonférence interne de la paroi de forme annulaire (131) est en contact avec une circonférence externe du substrat (110) de sorte que l'unité d'émission de lumière soit assise dans l'organe d'espacement.

**2.** Dispositif d'éclairage selon la revendication 1, dans lequel le substrat (110) comprend une portion plate (114), dans lequel l'organe d'espacement (130) comprend une portion plate (134), et dans lequel la portion plate (114) du substrat (110) et la portion plate (134) de l'organe d'espacement (130) sont en contact l'une avec l'autre.

**3.** Dispositif d'éclairage selon la revendication 1 ou 2, dans lequel l'unité d'émission de lumière (101) comprend en outre une électrode en plomb (170) transmettant de l'énergie aux dispositifs électroluminescents (120), et dans lequel l'organe d'espacement comprend en outre une portion traversée par l'électrode (135) à travers laquelle l'électrode en plomb (170) passe.

**4.** Dispositif d'éclairage selon l'une quelconque des revendications 1 à 3, dans lequel l'unité d'émission de lumière (101) comprend en outre une plaque réfléchissante (155) disposée sur le substrat (110).

**5.** Dispositif d'éclairage selon l'une quelconque des revendications 1 à 4, comprenant en outre un boîtier (900), dans lequel le boîtier (900) comprend :

un corps de boîtier (300) ayant un corps circulaire avec un espace logeant l'unité d'émission de lumière (101), l'organe d'espacement (130) et la lentille (140) ; et
un couvercle de boîtier (700) disposé sur le corps de boîtier (300) et ayant une forme annulaire circulaire comprenant une ouverture, et
dans lequel la lentille (140) comprend une surface de sortie sphérique (145) et une bride (144) disposée autour d'un fond de la surface de sortie (145),
dans lequel la surface de sortie (145) de la lentille (140) est disposée dans l'ouverture du couvercle de boîtier (700).

**6.** Dispositif d'éclairage selon la revendication 5, dans lequel le boîtier (900) comprend un trou de dissipation de la chaleur (930), dans lequel le corps de boîtier (300) comprend un premier trou de dissipation de la chaleur (330), dans lequel le couvercle de boîtier (700) comprend un second trou de dissipation de la chaleur (730), et dans lequel le trou de dissipation de la chaleur (930) est formé par le premier trou de dissipation de la chaleur (330) et le second trou de dissipation de la chaleur (730).

**7.** Dispositif d'éclairage selon la revendication 5 ou la revendication 6, dans lequel le couvercle de boîtier (700) comprend un côté interne (770) étendu à une inclinaison prédéterminée par rapport à une surface supérieure du couvercle de boîtier (700) vers le centre de l'ouverture du couvercle de boîtier (700).

**8.** Dispositif d'éclairage selon la revendication 7, comprenant en outre un anneau imperméable à l'eau (600) disposé entre le côté interne (770) du couvercle de boîtier (700) et la bride (144) de la lentille (140).

**9.** Dispositif d'éclairage selon la revendication 8, dans lequel l'anneau imperméable à l'eau (600) couvre une surface supérieure et une circonférence de la bride (144).

**10.** Dispositif d'éclairage selon l'une quelconque des revendications 5 à 9, dans lequel le corps de boîtier (300) comprend un filetage (320A) disposé sur une circonférence du corps de boîtier (300).

**11.** Dispositif d'éclairage selon l'une quelconque des revendications 1 à 4, dans lequel la lentille comprend :

une surface circulaire d'incidence (143) adaptée à recevoir de la lumière de l'unité d'émission de lumière et étant perpendiculaire à un axe de lumière incidente, la surface d'incidence comportant une rainure allongée (141) s'étendant le long d'un diamètre de la surface circulaire et ayant une largeur représentant entre 9 % et 40 % du diamètre de la surface d'incidence, et des surfaces de prisme (142) formées des deux côtés de la rainure allongée, les surfaces de prisme comprenant une pluralité de prismes allongés s'étendant dans une direction parallèle à la rainure allongée ;
une surface de sortie hémisphérique (145) qui réfracte et transmet la lumière traversant la surface d'incidence vers l'extérieur de la lentille ; et
une bride circulaire (144) qui est aménagée autour de la circonférence de la surface d'incidence.

【Fig. 1】

100

143
141 142 140
145

Z
−Y ← → +Y
X

144

G1

130
101 110 120 105 133 132

【Fig. 2】

101

D1

110 120

【Fig. 3】

【Fig. 4】

【Fig. 5】

101C

110

120

113

114

【Fig. 6】

101D

110

120

113

114

【Fig. 7】

【Fig. 8】

【Fig. 9】

【Fig. 10】

【Fig. 11】

【Fig. 12】

【Fig. 13】

【Fig. 14】

【Fig. 15】

【Fig. 16】

【Fig. 17】

【Fig. 18】

【Fig. 19】

【Fig. 20】

【Fig. 21】

【Fig. 22】

【Fig. 23】

【Fig. 24】

【Fig. 25】

【Fig. 26】

【Fig. 27】

【Fig. 28】

【Fig. 29】

【Fig. 30】

【Fig. 31】

EP 2 672 299 B1

【Fig. 32】

37

【Fig. 33】

【Fig. 34】

【Fig. 35】

【Fig. 36】

【Fig. 37】

【Fig. 38】

【Fig. 39】

【Fig. 40】

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 101174612 A

- EP 2078736 A1